(19) Europäisches Patentamt
European Patent Office
Office européen des brevets

(11) EP 1 892 573 B1

(12) **EUROPEAN PATENT SPECIFICATION**

(45) Date of publication and mention of the grant of the patent:
**02.11.2011 Bulletin 2011/44**

(51) Int Cl.:
***G03F 7/027*** *(2006.01)* ***C09D 11/00*** *(2006.01)*
***G03F 7/105*** *(2006.01)*

(21) Application number: **07016391.0**

(22) Date of filing: **21.08.2007**

(54) **Photopolymerizable composition comprising fine particles of organic pigment**

Photopolymerisierbare Zusammensetzung mit feinen Partikeln eines organischen Pigments

Composition photopolymérisable comprenant des particules fines de pigment organique

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **22.08.2006 JP 2006225548**

(43) Date of publication of application:
**27.02.2008 Bulletin 2008/09**

(73) Proprietor: **FUJIFILM Corporation**
**Minato-ku**
**Tokyo 106-8620 (JP)**

(72) Inventor: **Sugai, Masaharu**
**Haibara-gun**
**Shizuoka 4210396 (JP)**

(74) Representative: **HOFFMANN EITLE**
**Patent- und Rechtsanwälte**
**Arabellastraße 4**
**81925 München (DE)**

(56) References cited:
**EP-A- 0 953 613**
**EP-A- 1 612 247**
**US-A- 5 679 138**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Technical Field

The present invention relates to a photopolymerizable material which can be used in various applications such as the 3-dimensional optical moulding or holography, a plate material for forming lithographic printing plate, image-forming materials such as color proof, photoresists and color filters, and photocurable resin materials such as adhesives and ink. More particularly, the present invention pertains to an actinic ray-curable ink jet recording ink composition, which is excellent in the curability and gloss and which can form images of high quality.

### Background Art

The photopolymerizable composition containing an initiator (a photosensitizer) has a variety of advantages such that it can eliminate the necessity of any drying step through heating, that it can be cured within a short period of time, that it permits the easy production of goods having complicated shapes, and that it hardly causes any environmental pollution and accordingly, it has widely been used as, for instance, a photocurable ink, a photocurable adhesive, light-sensitive lithographic printing plate and a photoresist for forming a printed board. Such a composition if necessary contains a coloring substance such as a pigment and therefore, it may provide a colored and cured material after the irradiation thereof with light rays.

In case of the photopolymerizable composition containing a pigment, the quality of the resulting image is greatly affected by the size of the pigment particles and the width of the particle size distribution.

The methods for the preparation of organic pigment fine particles are roughly divided into the breakdown method in which a bulk material is pulverized into fine particles, and the build-up method in which fine particles are grown in a gas phase or in a liquid phase (see Non-patent Document 1 specified below). In general, the breakdown method (pulverization method) has widely been employed, but it is difficult to obtain fine particles of an organic substance having a size of the nanometer order (nano-particles) according to this method. In addition, by this method, nano-particles may be obtained in only a considerably low productivity, and only a limited number of substances can be applied to this method.

Contrary to this, there has recently been investigated a method for preparing nanometer-sized organic fine particles according to the build-up method. An example thereof is, for instance, a production method which makes use of the micro-chemical process (see Patent Document 1 specified below). However, the method has still been insufficient for satisfying, on a high level, the recent requirements for ink jet recording ink and accordingly, there has been desired for the further improvement of such a method or for the development of another new method.

On the other hand, there have been known, for instance, the electrophotographic technique, the sublimation-type or molten-type heat-transfer technique, and the ink jet recording technique, as the image-recording technique in which images are formed on a medium to be recorded such as paper on the basis of image data signals. The electrophotographic technique requires the use of a process for forming electrostatic latent images on a light-sensitive drum through charging and light-exposure steps and accordingly, this technique suffers from such a problem that the use of such steps makes the system complicated and that the production cost thereof correspondingly increases. In addition, the heat-transfer technique requires the use of a cheap device, but requires the use of an ink ribbon and this becomes a cause of additional problems such that the running cost of the method increases and that the method would yield a large amount of scrap materials or waste. On the other hand, the ink jet recording method uses a cheap device and can directly form images on a recording medium by injecting or discharging ink only on the desired image-forming portion on the medium and therefore, the running cost of this method is quite low. Furthermore, the device never makes so many noises and accordingly, this method is excellent as an image-recording system.

Among the image-recording systems according to the ink jet recording methods, the ink jet recording system which makes use of an ink capable of being cured through the irradiation of radiant rays such as ultraviolet light rays has become of major interest lately since the system does not give out a large quantity of bad smells, the ink used has quick-drying characteristics and the system permits the recording even on a recording medium free of any ink absorptivity. Such a radiation-curable ink composition should have a sufficiently high sensitivity (curability) and should have an ability to provide a printed matter which has a sufficiently high glossiness and which carries images of high quality.

However, the conventional pigments have not yet satisfactorily fulfilled such requirements and there have still been desired for the further improvement of such pigments and for the development of novel high quality pigments (see

Patent Document 1: Japanese Un-Examined Patent Publication 2005-307154;
Non-Patent Document 1: "Jikken Kagaku Koza (Experimental Chemistry), Fourth Edition", edited by Chemical Society of Japan, Vol. 12, pp. 411-488, MARUZEN Publishing Co., Ltd.)

EP 0 953 613 relates to an ink for ink-jet recording containing a coloring agent, a polymerizable oligomer, water

and photopolymerizable initiator having a solubility in water of 3 percent by weight or more.

US 5,679,138 relates to an ink jet printing method for producing images by the deposition of ink droplets on a substrate in response to digital signals. The process comprises a step mixing the pigment dispersion with a rigid milling media having an average particle size less than 100 μm.

Disclosure of the Invention

Accordingly, it is an object of the present invention to provide a photopolymerizable composition which is highly sensitive to light rays, and which can form glossy images of high quality.

It is a further object of the present invention to provide an actinic ray-curable ink jet recording ink composition, which is highly sensitive to light rays, and which can form glossy images of high quality.

According to the present invention, it has been found that the foregoing object of the present invention can be accomplished by providing a photopolymerizable composition comprising the following components: a) a photopolymerizable compound; b) a photopolymerization initiator; and c) organic pigment fine particles on which a polymer formed from a polymerizable compound is immobilized, wherein the volume average particle size: Mv of the organic pigment fine particles is not more than 50 nm, and the ratio: Mv/Mn (wherein Mv represents the volume average particle size of the organic pigment fine particles and Mn represents the number average particle size thereof) ranges from 1 to 1.5

According to the present invention, it has further been found that the foregoing problems associated with the conventional technique can be accomplished by providing an ink jet recording ink composition which comprises the following components: a) a photopolymerizable compound; b) a photopolymerization initiator; and c) organic pigment fine particles on which a polymer formed from a polymerizable compound is immobilized, wherein the volume average particle size: Mv of the organic pigment fine particles is not more than 50 nm, and the ratio: Mv/Mn (wherein Mv represents the volume average particle size of the organic pigment fine particles and Mn represents the number average particle size thereof) ranges from 1 to 1.5.

The organic pigment fine particles as a component of the foregoing ink composition are desirably those dispersed in water.

The use of the photopolymerizable composition according to the present invention would permit the achievement of a high sensitivity of a recording ink and the formation of glossy images showing high quality.

Moreover, when using the photopolymerizable composition according to the present invention as an actinic light ray-curable ink composition, the ink composition has a high sensitivity to radiation and permits the formation of glossy images showing high quality. Surprisingly, the resulting ink composition has likewise good transparent feeling as compared with the composition prepared using the conventional pigment.

**Brief Description of the Drawings**

The present invention will hereunder be described in more detail while referring to the attached figures, wherein:

Fig. 1A is a diagram for explaining a reaction device provided with, on the one side, a Y-shaped flow path;
Fig. 1B is a cross-sectional view of the device as shown in Fig. 1A, taken along the line 1B-1B on Fig. 1A;
Fig. 2A is a diagram for explaining a reaction device provided with a cylindrical flow path to which a sub-flow path formed on one side thereof is connected;
Fig. 2B is a cross-sectional view of the device as shown in Fig. 2A, taken along the line 2B-2B on Fig. 2A;
Fig. 2C is a cross-sectional view of the device as shown in Fig. 2A, taken along the line 2C-2C on Fig. 2A;
Figs. 3A is a diagram for explaining a reaction device provided with, on the both sides, Y- shaped flow paths;
Fig. 3B is a cross-sectional view of the device as shown in Fig. 3A, taken along the line 3B-3B on Fig. 3A;
Fig. 4 is a diagram for explaining a reaction device provided with a cylindrical flow path to which sub-flow paths formed on the both sides thereof are connected;
Fig. 5 is a diagram for explaining an embodiment of a planar microreactor device;
Fig. 6 is a diagram for explaining a further embodiment of a planar microreactor device;
Fig. 7 is a diagram for explaining a still further embodiment of a planar microreactor device.

Fig. 8 is an exploded and perspective view of a three-dimensional microreactor device, depicted in its disassembled condition, according to the stereographic technique.

**Best Mode for Carrying Out the Invention**

(1) Photopolymerizable Composition

The photopolymerizable composition of the present invention comprises the following components: a) a photopolymerizable compound; b) a photopolymerization initiator; and c) fine particles of an organic pigment, on which a polymer formed from a polymerizable compound is immobilized, wherein the volume average particle size: Mv of the organic pigment fine particles is not more than 50 nm, and the ratio: Mv/Mn (wherein Mv represents the volume average particle size of the organic pigment fine particles and Mn represents the number average particle size thereof) ranges from 1 to 1.5.

(1-1) Organic Pigment Fine Particles

In the composition of the present invention, a polymer formed from a polymerizable compound is immobilized on the organic pigment fine particles, wherein the volume average particle size (Mv) of the organic pigment fine particles is not more than 50 nm and the ratio: Mv/Mn (wherein Mv represents the volume average particle size of the organic pigment fine particles and Mn represents the number average particle size of the same) ranges from 1 to 1.5.

In this specification, the term "volume average particle size (Mv)" means the particle size determined on the basis of the volumes of particles and then arithmetically averaged and can easily be determined according to any known method such as static light- scattering technique, kinetic light-scattering technique and centrifugal sedimentation technique as well as those disclosed in "Jikken Kagaku Koza (Experimental Chemistry), Fourth Edition", edited by Chemical Society of Japan, Vol. 12, pp. 411-488. In this specification, the data listed herein are those determined using Microtruck UPA150 available from Nikkiso Co., Ltd.

The term "number average particle size (Mn)" herein used means the particle size determined on the basis of the number of particles and then arithmetically averaged and can be determined according to the same method listed above in connection with the volume average particle size. The data reported herein are those determined using Microtruck UPA150 available from Nikkiso Co., Ltd.

The value obtained by dividing the volume average particle size (Mv) by the number average particle size (Mn) (Mv/Mn) is a value serving as an indication for the monodispersibility of particles. The lower the value or the ratio, or the closer the value to 1, the more excellent the monodispersibility of the particles.

The volume average particle size (Mv) of the organic pigment fine particles is not more than 50 nm, preferably 3 to 40 nm and more preferably 10 to 30 nm. The use of organic pigment fine particles having a volume average particle size specified above is particularly preferred in case of the ink jet recording ink since images of high quality can be obtained.

The ratio: Mv/Mn (Mv: the volume average particle size of the organic pigment fine particles and Mn= the number average particle size of the same) ranges from 1 to 1.5, preferably from 1.3 to 1.5 and more preferably from 1.4 to 1.5.

The fact that particles have a uniform particle size or that particles are in the monodispersed particle system means that the particles included in the system are not only uniform in their size, but also free of any difference in the chemical composition and the crystalline structure between particles and this is an important factor for the determination of the quality of the particles. In particular, in case of ultrafine particles whose particle size is on the order of nanometers, this would be considered as a quite important factor for governing the characteristic properties of the particles. The method, as will be detailed later, for preparing a dispersion of organic pigment fine particles would permit not only the formation of fine particles having a very small particle size, but also the control of the particle size to prepare uniformly sized particles.

Furthermore, it is preferred, in the present invention, that the organic fine pigment particles have high stability. In this respect, the rate of variation in the particle size observed when storing the same can be used as an indicator of the stability and it can be expressed in terms of, for instance, the rate of variation in the volume average particle size (Mv). The organic pigment fine particles used in the present invention are preferably those having a rate of variation of not more than 6.0%, more preferably not more than 5.0% and particularly preferably not more than 4.0%, wherein the rate of variation is determined after a heating/storing treatment (for instance, such a treatment is carried out at a temperature ranging from 60 to 80°C for 50 to 300 hours).

In the composition of the present invention, the content of the organic pigment fine particles can appropriately be determined while taking into consideration each particular application thereof, but it preferably ranges from 0.3 to 15% by mass on the basis of the total mass of the composition while taking into consideration the color density required for obtaining images of high quality and the viscosity value suitably selected for, in particular, the ink jet recording ink.

The foregoing organic pigment fine particles can be converted into a dispersion thereof according to the following methods: A method for the preparation of a dispersion of organic pigment fine particles which comprises the steps of incorporating a polymerizable compound into either or both of (a) an alkaline or acidic solution containing an organic

pigment (raw material) and (b) an aqueous medium, blending the solution (a) and the medium (b) together to thus separate out fine particles of the foregoing pigment, and then polymerizing the polymerizable compound to thus immobilize the polymer of the polymerizable compound onto the surface of the pigment fine particles formed above.

In the method for preparing the dispersion of organic pigment fine particles used in the present invention, the solution (a) containing a dissolved organic pigment is admixed with the aqueous medium (b) to thus precipitate fine particles of the organic pigment during the mixing operation. In this respect, the solution (a) and the medium (b) are blended together according to, for instance, a method in which the organic pigment solution (a) is poured into the aqueous medium (b) or vice versa or the solution (a) and the medium (b) are simultaneously admixed together. At this stage, it is preferred to agitate the mixture for the acceleration of the mixing operation.

Alternatively, these liquids can likewise be blended while making use of a flow path and in this case, the solution (a) and the medium (b) can be admixed together by passing these liquids through a flow path so that they are brought into close contact with one another. In other words, a pigment dispersion can be prepared according to the continuous flow method [in this case, however, the method for bringing a plurality of liquids into close contact with one another in a flow path to thus blend them is different from the jet method which cannot precisely control the contact time and reaction time] or the method for bringing them into contact with one another by spraying them through nozzles, which is disclosed in, for instance, Japanese Un-Examined Patent Publication (hereunder referred to as "J.P. KOKAI") 2002-155221 and U.S. Patent No. 6,537,364. At this stage, it is preferred that these liquids are passed through the flow path in the form of laminar flows to thus make them contact with one another at the interface of these laminar flows. The device usable herein may be any one insofar as it is provided with a flow path capable of forming laminar flows therein and the flow path is preferably one having an equivalent diameter which permits the formation of a microscopic reaction field within the same.

The equivalent diameter is a term currently used in the field of mechanical engineering. When assuming a circular pipe equivalent to a piping having any cross-sectional shape, which corresponds to a flow path in the present invention, the diameter of the equivalent circular pipe is defined to be "equivalent diameter". The equivalent diameter ($d_{eq}$) can be defined to be $d_{eq} = 4A/p$ (wherein A represents the cross-sectional area of the piping and p represents the peripheral length of the piping). When applying this relation to a circular pipe, the equivalent diameter is in agreement with the diameter of the circular pipe. The equivalent diameter is used for estimating the flowing and heat-transfer characteristics of the piping on the basis of the data observed for the equivalent circular pipe and it likewise represents the spatial scale (representative length) of the phenomenon. The equivalent diameter is defined to be as follows: $d_{eq} = 4a^2/4a = a$ (for a pipe having a square cross-section and having the length of the side of a); and

$$d_{eq}=a/\sqrt{3}$$

(for an equilateral triangle having the length of the side of a).

The equivalent diameter for a flow between parallel plates having a height h of the flow path is as follows: $d_{eq} = 2h$ (see, for instance, "Kikai-Kougaku-Jiten" (Mechanical Engineering Dictionary), edited by Mechanical Society of Japan (Incorporated Body), 1997, Published by MARUZEN Publishing Co., Ltd.).

When water is passed through the pipe, a fine tube is inserted into the pipe along the center line thereof and a colored liquid is injected into the same, the colored liquid passes through the pipe as a single line and the water straightly passes through the same along the wall of the pipe, while the flow rate of water is low. When the flow rate of the water increases and it is arrived at a desired level, however, the water flow is suddenly disturbed, the colored liquid is thus admixed with the water flow to thus give a single entirely colored flow. The former flow is referred to as "laminar flow", while the latter flow is referred to as "turbulent flow".

The condition of a flow (whether each specific flow is a laminar flow or a turbulent flow) may be determined on whether the Reynolds number which shows the behavior of a flow and is a dimensionless number is smaller than a critical value or not. The smaller the Reynolds number, the easier the formation of a laminar flow. The Reynolds number (Re) for a flow within a pipe can be represented by the following relation:

$$Re = D\langle v_x \rangle \rho / \mu$$

wherein D represents the equivalent diameter of the pipe, $\langle v_x \rangle$ represents the cross-sectional average flow rate, $\rho$ represents the density of the liquid, and $\mu$ represents the viscosity of the liquid. As will be clear from the equation, the smaller the equivalent diameter, the smaller the Reynolds number and therefore, when the equivalent diameter is on the order of $\mu$m, a stable laminar flow can easily be formed. Moreover, the Reynolds number is likewise affected by the

physical properties such as the density and viscosity of a liquid and the lower the density of the liquid and the higher the viscosity thereof, the smaller the Reynolds number. Accordingly, a laminar flow can easily be formed.

The Reynolds number corresponding to its critical level is referred to as the "critical Reynolds number". The critical Reynolds number is not always constant, but the following values will serve as approximate standards:

| | |
|---|---|
| $Re < 2300$ | Laminar Flow; |
| $Re > 3000$ | Turbulent Flow; and |
| $3000 > Re \geqq 2300$ | Transient Condition |

The smaller the equivalent diameter of a flow path, the greater the surface area per unit volume (specific surface area). However, the flow path is reduced even to a scale of micron order, the specific surface area becomes considerably large and correspondingly, the heat transfer rate through the wall of the flow path is significantly increased. The time required for the heat transfer (t) within the liquid passing through the flow path is represented by the following relation: $t = d_{eq}^2/\alpha$ ($\alpha$: heat-diffusion coefficient of the liquid) and therefore, the smaller the equivalent diameter, the shorter the heat transfer time (t). In other words, if the equivalent diameter is reduced to 1/10, the heat transfer time is reduced to 1/100 and when the equivalent diameter is reduced to a scale of micron order, the heat transfer rate becomes quite high.

More specifically, the Reynolds number is small in a micron-sized space whose equivalent diameter is on the order of micron size and therefore, a reaction can be carried out according to the flow method (flow reaction), which is governed by a stable laminar flow. In addition, the interfacial area between laminar flows is quite large and accordingly, the molecular diffusion through the interface permits the extremely fast and precise blending of component molecules, while maintaining a stable laminar flow conditions. Moreover, it is also possible to precisely control the reaction temperature while making the most use of the wall of the flow pass having a large surface area and to precisely control the reaction time through the control of the flow rate during the flow reaction. Accordingly, the microscopic reaction field used in the present invention is thus defined to be a micron-scale flow path having an equivalent diameter as a field in which the reaction can highly precisely be controlled according to the foregoing method, among the flow paths which can form laminar flows.

As has been discussed above in connection with the description of the Reynolds number, the formation of a laminar flow is greatly affected by not only the size of the equivalent diameter, but also the flow conditions including physical properties of a liquid such as the viscosity and density of the liquid. For this reason, the equivalent diameter of a flow path is not restricted to any specific one, insofar as a laminar flow can be formed within the same, and it preferably has a size which permits the easy formation of a laminar flow. The size thereof is preferably not more than 10 mm, more preferably not more than 1 mm, which allows the formation of a microscopic reaction field, further preferably 10 $\mu$m to 1 mm and particularly preferably 20 to 300 $\mu$m.

In the present invention, a typical reaction device provided with particularly preferred flow paths (or channels) of a micron-scale size is generally called "microreactor(s)" and they have recently been advanced greatly (see, for instance, W. Ehrfeld, V. Hessel, H. Loewe, "Microreactor", 1st Ed., 2000, WILEY-VCH).

The foregoing currently used microreactor is equipped with a plurality of microscopic flow paths (micro-flow paths) which have an equivalent diameter ranging from about several micrometers ($\mu$m) to several hundreds of micrometers ($\mu$m), as determined when the cross section thereof is reduced to a circular one, and a mixing space which is connected to these micro-flow paths and the microreactor of this type would permit the blend of a plurality of liquids or solutions or the simultaneous blend and reaction of the liquids, by passing the plurality of solutions through the plurality of micro-flow paths to thus guide them into the mixing space.

Then the principal difference between the reaction carried out using a microreactor and the batch-wise reaction carried out using, for instance, a tank will be detailed below. In a liquid phase chemical reaction or a chemical reaction taking place in a two-phase system, the reaction generally takes place when reactant molecules come in close contact with one another at the interface of these reactant solutions and therefore, when they are reacted in a quite small space (micro-flow path), the interfacial area between these solutions correspondingly increases and this accordingly leads to a significant improvement in the reaction efficiency. In addition, regarding the diffusion of the reactant molecules per se, the diffusion time is proportional to the square of the diffusion distance. This clearly indicates that, as the scale of the reactor used is reduced, the reactant solutions are blended through the diffusion of the reactant molecules and easily undergo the reaction between them even if the solutions are not actively or intentionally mixed together. Furthermore, the flow in a very small space principally consists of a laminar flow because of its small Reynolds number (a dimensionless number characteristic of such a flow), the molecular exchange between the reactant solutions takes place at the interface between the solutions both in the laminar flow states and the molecules thus exchanged undergo separation and/or reaction.

When using a microreactor having such characteristic properties, the time required for the reaction between reactant solutions and the reaction temperature can precisely be controlled as compared with the conventional batch-wise reaction method which makes use of a tank having a large volume as a reaction field. In addition, in case of the batch-wise reaction, in particular, those between reactant solutions whose reaction rate is quite high, the reaction thereof proceeds at the contact surface of these solutions formed at the initial stage of the mixing and the primary reaction products formed through the reaction between these solutions may sometimes undergo an additional reaction within the container. This may accordingly lead to the formation of non-uniform reaction products and the excess growth of crystals of the reaction products even to an undesirable extent in the mixing container to thus give coarse crystals. Contrary to this, the use of a microreactor would permit the almost continuous passage of such reactant solutions through the mixing container without causing any retention, it can thus prevent the occurrence of any retention of such primary reaction products formed through the reaction between these solutions and the occurrence of any additional reaction thereof, it can likewise permit the withdrawal of such primary reaction products in their pure states, which cannot recovered according to the conventional method and it would make it difficult to cause any agglomeration and/or to form coarse crystals within the mixing container.

When a small amount of a chemical substance is first prepared using a manufacturing investment of a laboratory size and the chemical substance is then prepared using manufacturing investment of a large-scale (scale-up of the manufacturing device), there has conventionally been required the use of much labor and time to ensure the reproducibility even when using a batch-wise manufacturing device of a large-scale, but the labor and time required for the achievement of such reproducibility may considerably be reduced by arranging, in a row (numbering up), a desired number of production lines established through the use of microreactors, the number of which is proportional to the desired quantity of the substance.

The following are the detailed description of a method for forming a flow path for establishing a laminar flow, which can be used in the preparation of a dispersion of organic pigment fine particles. When the flow path has a size on the order of not less than 1 mm, it can relatively easily be produced while making use of the usual mechanical processing technique, but it would increasingly be quite difficult to produce a flow path having a size of micron order on the order of not more than 1 mm, in particular, not more than 500 μm. In most of cases, such a flow path of micron order (a micro-flow path) is produced on a solid substrate according to the fine patterning technique. Such a solid substrate is not restricted to specific one insofar as it is a hardly corrosive stable material. Specific examples thereof include metals (such as stainless steel, Hastelloy (Ni-Fe type alloys), nickel, aluminum, silver, gold, platinum, tantalum or titanium), glass materials, plastic materials, silicone, Teflon (registered trade mark) or ceramics.

Typical examples of fine patterning techniques used for forming micro-flow paths are as follows: the LIGA techniques which make use of the X-ray lithography technique (Roentgen-Lithographie Galvanik Abformung); the high aspect ratio-photolithography technique using EPON SU-8 (trade name); the micro-discharge processing technique (μ -EDM (Micro-Electro Discharge Machining)); the high aspect ratio-processing technique for silicon, according to Deep RIE (Reactive Ion Etching); the Hot Emboss processing technique; the photo-molding technique; the laser-processing technique; the ion beam

- processing technique; and the mechanical micro-cutting technique which makes use of a micro-tool made of a hard material such as diamond. These techniques may be used alone or in any combination. Examples of fine patterning techniques preferably used herein are the LIGA techniques which make use of the X-ray lithography technique; the high aspect ratio-photolithography technique using EPON SU-8 (trade name); the micro-discharge processing technique (μ-EDM); and the mechanical micro-cutting technique. Moreover, there has recently been investigated the application of microscopic injection-molding technique to the engineering plastics.
  The joining (bonding) technique has frequently been used in the production of a micro-flow path. The usual joining techniques are roughly divided into the solid-phase and liquid-phase joining techniques and typical examples of such joining techniques currently used include solid-phase joining techniques such as the pressure-joining and diffusion-joining techniques; and the liquid-phase joining techniques such as the soldering, eutectic joining, soldering and adhering techniques. In addition, it is preferred to use a highly precise joining technique which can maintain its dimensional precision and which is free of any breakage of fine structures such as flow paths due to any deterioration and/or strong deformation of the material by the action of the heat applied thereto upon the assembly thereof. Examples of such techniques are the silicon direct joining, anode-joining, surface-activation joining, direct joining while making use of hydrogen bonds, joining using an HF solution, Au-Si eutectic joining, and void-free adhesion techniques.
  The micro-flow paths usable herein may be not only those produced on solid substrates according to the fine patterning technique, but also a variety of commercially available fused silica capillary tubes each having an inner diameter ranging from several micrometers to several hundreds of micrometers. Usable herein as such micro-flow paths further include, for instance, various kinds of silicone tubes each having an inner diameter ranging from several micrometers to several hundreds of micrometers commercially available as parts for the high performance liquid chromatography and for the gas chromatography; tubes made of fluorine plastics; stainless steel tubes; and PEEK tubes (polyether-ether-ketone tubes).

Regarding the microreactors, there have conventionally been reported devices developed while aiming at the improvement of the reaction efficiency. For instance, such micro-mixers and microreactors are disclosed in, for instance, J.P. KOKAI Nos. 2003-210960, 2003-210963, 2003-210959, 2005-46650, 2005-46651, 2005-46652 and 2005-288254; and accordingly, the foregoing micro-devices may be used in the preparation of the dispersion of organic pigment fine particles used in the present invention.

The micro-flow path may be subjected to a surface-treatment depending on any particular purposes. In particular, when handling an aqueous solution, the surface- treatment is quite important since a problem sometimes arises such that the sample is adhered to the surface of glass and/or silicon materials or parts. In this respect, it is desirable to make, possible, the control of a liquid within micron-sized flow paths without incorporating any movable part which requires a complicated manufacturing process. For instance, hydrophilic and hydrophobic zones are formed within the flow path through such a surface-treatment and the liquid can be operated while making use of the difference in the surface tension acting on the interface. The surface-treatment using a silane-coupling agent which can make the surface hydrophobic or hydrophilic is a method widely used for the treatment of the surface of glass or silicon materials.

The functions for controlling liquids should be used to blend reagents and/or samples by the introduction thereof into desired flow paths. In particular, the behaviors of fluids within micro-flow paths would substantially be different from those observed for a reactor of a macro-scale and therefore, it is necessary to devise or adopt any controlling means suitably used for a micro-scaled reactor. The fluid-control systems can be classified, on the basis of the mode thereof, into the continuous-flow system and the droplet (liquid plug) system, while they can likewise be divided, on the basis of the driving force, into the electrically driven system and the pressure-driven system.

These systems will hereunder be described in more detail. The most widely used as the mode for handling fluids is the continuous flow system. In the fluid control of such continuous flow system, it is common that the interior of the micro-flow paths are completely filled with a fluid and the entire fluid is driven by an externally provided pressure source such as a syringe pump. This method suffers from a problem such that the dead volume is quite large, but it is quite advantageous that the control system can be realized by a relatively simple setup.

There has likewise been known the droplet (liquid plug) system as a substitute for the foregoing continuous flow system. According to this system, droplets each partitioned by an air layer is moved through the interior of the reactor or flow paths communicated with the reactor and the individual droplet is driven by the air pressure. In this respect, the reactor system should internally and preliminarily be provided with, for instance, a vent structure for externally discharging, if needed, the air present between the droplet and the wall of the flow path or between the neighboring droplets and a valve structure for holding the pressure in one of the branched flow paths independent of that observed in the other flow path. Moreover, it is also necessary to externally assemble a pressure-control system which comprises a pressure source and a switching valve. As has been described above, the droplet system requires the use of a rather complicated device construction and a likewise complicated reactor structure, but the multi-stage operations can be performed, or several reactions can be carried out in order, while operating a plurality of droplets independently and accordingly, this system may significantly increase the degree of freedom in the constitution of the system or the system design.

As the driving system for carrying out the fluid control, there have widely been used currently, for instance, the electric driving method in which a high voltage is applied to the both ends of a flow path (a channel) to thus generate an electro-osmotic flow and to thus move the fluid; or the pressure-driving method wherein a pressure is applied to the fluid while making use of an externally disposed pressure source to thus move the fluid. It has been known that the difference between these methods is as follows: regarding, for instance, the behavior of a fluid, the flow rate profile within the cross-section of the flow path shows a flat distribution in case of the electric driving method, while that observed for the pressure-driving method shows a hyperbolic curve-like distribution or a distribution such that the flow rate is high in the proximity to the center of the cross-section and it is gradually reduced towards the wall of the flow path. Accordingly, the electric driving method is rather preferred for the purpose of moving the sample while maintaining the sample plug shape. When carrying out the electric driving method, the flow path should be filled with a fluid and the continuous-flow system should correspondingly be employed. However, the fluid can be operated through an electrical control means, the electric driving method permits the realization of a relatively complicated treatment such that the mixing ratio of two kinds of solutions is continuously changed to thus establish a concentration gradient which may vary with time. In case of the pressure-driving method, for instance, the fluid can be controlled irrespective of the electric characteristics of the same and it is not necessary to take into consideration such secondary or minor effects as heat-generation and electrolysis. Accordingly, any substrate is not adversely affected by the method and the method thus has quite wide applications. On the other hand, the method suffers from a problem such that a pressure source should externally be provided and that the response characteristics of the operations may vary depending on the size of the dead volume of the pressure-application system and accordingly, such complicated operations should be automated.

These fluid-control methods are appropriately selected on the basis of each particular purpose, but preferably used herein are pressure-driving methods according to the continuous-flow system.

The temperature within the flow path may be controlled by a method in which an entire device provided with flow paths is introduced into a container maintained at a desired controlled temperature; or a method in which the flow path is heated using a heater structure of, for instance, a metallic resistance wire or a polysilicon material incorporated into the device, while it is air-cooled or spontaneously cooled to thus form a thermal cycle. When using a metallic resistance wire, the temperature is preferably detected by incorporating, into the device, another or secondary resistance wire identical to that used in the heater and detecting the temperature on the basis of the variation in the resistance value detected by the secondary resistance wire, while if using a polysilicon, the temperature is preferably detected using a thermocouple. In addition, a Peltier element is brought into contact with the flow path to thus externally heating and cooling the device or the flow path. These methods are appropriately selected while taking into consideration the applications and the kinds of materials of the flow path body.

When fine particles are precipitated during passing the reactant solutions through the flow paths, the reaction time can be controlled by adjusting the retention time of the solutions in the flow paths. The retention time is determined by the length of the flow path and the introduction speed thereof when the equivalent diameter is constant. The length of the flow path is not restricted to any particular one, but it is preferably not less than 1 mm and not more than 10 m, more preferably not less than 5 mm and not more than 10 m, and particularly preferably not less than 10 mm and not more than 5 m.

In the method for the preparation of a dispersion of organic pigment fine particles, the number of the flow paths used therein is not particularly restricted and can appropriately be determined. Accordingly, it may be one, but a desired number of flow paths may be arranged in a row (numbering up) according to need to thus increase the throughput.

Attached figures 1A to 8 show reaction devices preferably used in the method for the preparation of a dispersion of organic pigment fine particles. In this respect, however, the present invention is not restricted to the use of these specific reaction devices.

Fig. 1A is a diagram for explaining a reaction device (10) equipped with a Y-shaped flow path and Fig. 1B shows the cross-sectional view thereof taken along the line 1B-1B on Fig. 1A. The shape of the cross-section perpendicular to the longitudinal direction of the flow path may vary depending on the fine patterning or processing technique selected, but it is similar to a rectangular or trapezoidal shape. When the flow path is so designed that it has micron-size width and depth (in particular, C, H), the solutions which are injected into the same through introducing ports 11 and 12 using, for instance, a pump are brought into contact with one another at the junction 13d through introducing flow paths 13a and 13b to thus form stable laminar flows and the resulting laminar flows pass through the reaction flow path 13c. The solutes contained in these laminar flows are admixed together or undergo a reaction between them due to the diffusion thereof at the boundary between these laminar flows, while these solutions flow through the path in the form of such laminar flows. In some cases, the solutes having very low diffusion rates do not cause any uniform mixing between the laminar flows through the diffusion thereof or they are not admixed together until they reach the discharge port 14. When two kinds of solutions injected into the flow path are easily blended in a flask, the flow of the fluid at the discharge port becomes uniform if the length F of the flow path is sufficiently increased, but the laminar flows are maintained even to the discharge port when the flow path length F is short. When, in a flask, two kinds of solutions injected into the flow path are not blended, but cause phase-separation, it is a matter of course that these two solutions flow through the same in the form of laminar flows and arrive at the discharge port 14.

Fig. 2A is a diagram for explaining a reaction device (20) provided with a cylindrical flow path to which a sub-flow path formed on one side thereof is connected, Fig. 2B is a cross-sectional view of the device taken along the line 2B-2B on Fig. 2A and Fig. 2C is a cross-sectional view of the device taken along the line 2C-2C on Fig. 2A. The shape of the cross-section perpendicular to the longitudinal direction of the flow path is a circle or one similar thereto. When the flow path of such cylindrical tube has a micron-size diameter (D, E), the solutions which are injected into the same through introducing ports 21 and 22 using, for instance, a pump are brought into contact with one another at the fluid junction 23d through introducing flow paths 23a and 23b to thus form stable cylindrical-shaped laminar flows and the resulting laminar flows pass through the reaction flow path 23c. As a result, the solutes contained in these laminar flows are admixed together or undergo a reaction between them due to the diffusion thereof at the boundary between these laminar flows, while these solutions flow through the path in the form of such cylindrical laminar flows, as has already been discussed above in connection with the device shown in Fig. 1A. The device of this embodiment having a cylindrical flow path permits the substantial increase of the area of the boundary formed between these two solutions as compared with the device shown in Fig. 1A and the resulting boundary is completely free of any contact with the wall of the device. Accordingly, when solids (crystals) are, for instance, formed through the reaction, the device does not suffer from such problems that crystals grow at the contact area between the wall of the device and the boundary and that the flow path is clogged.

Figs. 3A and 4 show devices similar to those depicted on Figs. 1A and 2A, which are improved in that, when two liquids reach the discharge port while they are maintained in their laminar flow states, they can be separated from

one another. The use of these devices would permit the reaction of these liquid and the separation thereof, simultaneously. Moreover, these devices can prevent any ultimate blending of these liquids or any extreme progress of the reaction, as well as any excess crystal growth. When the reaction products or crystals are selectively formed only in one liquid, the reaction products or crystals can be formed at a higher concentration as compared with that achieved when these liquids are completely blended. In addition, a desired number of such devices are connected to one another to thus make the extraction operations more efficient.

A microreactor 50 as shown in Fig. 5 is so designed that it comprises a flow path 51 for supplying a solution A, which is divided into two branched flow paths 51A, 51B in the middle thereof so as to branch the liquid A into two flows; a flow path 52 free of any branch and for supplying a liquid B; and a micron-sized flow path 53 for reacting the liquid A with the liquid B, and that these flow paths are communicated to one another at a junction zone 54. In addition, these branched flow paths 51A, 51B, the flow path 52 and the micron-sized flow path 53 are arranged on the substantially the same plane at equal intervals of 90 degrees around the junction zone 54. More specifically, the central axes (alternate long and short dash line) of these flow paths 51A, 51B, 52, 53 intersect one another in the junction zone 54 in a cross-shape (cross angle $\alpha$ = 90 deg.). In this respect, in Fig. 5, only the flow path 51 for supplying the liquid A whose amount to be supplied is greater than that of the liquid B, is branched into two flow paths, but the flow path 52 for supplying the liquid B can likewise be divided into a plurality of flow paths. Moreover, the cross angle $\alpha$ for these flow paths 51A, 51B, 52, 53 is not restricted to 90 deg. and accordingly, it may appropriately be selected. In addition, the number of division of the flow paths 51 and 52 is not restricted to any particular one, but if it is too high, the resulting microreactor device 50 has an extremely complicated structure. Therefore, it preferably ranges from 2 to 10 and more preferably 2 to 5.

Fig. 6 is a diagram for explaining another embodiment of the planer microreactor device 50 as shown in Fig. 5. In this device, the cross angle $\beta$ between the center line of the flow path 62 and the center lines of the branched flow paths 61A and 61B is set at a level of 45 deg., which is smaller than that (90 deg.) as shown in Fig. 5. In addition, the cross angle $\alpha$ between the center lines of the branched flow paths 61A and 61B and the center line of the micron-sized flow path (hereunder referred to as micro-flow path) 63 is set at a level of 135 deg.

Fig. 7 is a diagram for explaining a still further embodiment of a planar microreactor device as shown in Fig. 5. In this device, the cross angle $\beta$ between the center line of a flow path 72 through which a liquid B passes and the center lines of branched flow paths 71A, 71B through which a liquid A passes is set at a level of 135 deg., which is larger than that (90 deg.) as shown in Fig.5. In addition, the cross angle $\alpha$ between the center lines of the branched flow paths 71A, 71B and the center line of a micron-flow path 73 is set at a level of 135 deg. The cross angles $\alpha$ and $\beta$ between the flow path 72 and the branched flow paths 71A, 71B and between the branched flow paths 71A, 71B and the micron-flow path 73, respectively can appropriately be selected, but it is preferred that these cross angles $\alpha$ and $\beta$ be set at levels such that the relation: S 1>S2 is satisfied. In the relation, S1 represents the sum of cross sectional areas in the direction of the thickness of the combined whole solutions A and B and S2 represents the cross sectional area of the micron-flow path 73 in the radial direction. This is because, if the angles fulfill the foregoing relation, the contact area between the solutions A and B can further be increased and the diffusion-mixing distance between them can likewise further be reduced and accordingly, these solutions can easily undergo instantaneous mixing.

Fig. 8 shows an embodiment of a three-dimensional microreactor device 80 and is an exploded and perspective view thereof, which is depicted in a state disassembled into three parts constituting the same. This three-dimensional microreactor device 80 mainly comprises a supply block 81, a junction block 82 and a reaction block 83, these blocks being in cylindrical shapes. In this regard, the microreactor device 80 can be assembled by arranging these cylindrical blocks 81, 82 and 83 into a cylindrical shape, in this order, such that the sides thereof are brought into contact with one another and then they are fastened, in a body, with a bolt and a nut, while maintaining this arrangement.

On the side of the supply block 81 opposed to the junction block 82, two circular grooves 84, 85 are concentrically formed on the side thereof and the circular groove 84 or 85 forms a ring-shaped flow path through which each corresponding solution A or B is passed, when the microreactor 80 is in its assembled state. Moreover, a through hole 87 or 88 is formed in such a manner that the side 94 of the supply block 81 which is not opposed to the junction block 82 is communicated with the internal ring-like groove 85 or the external ring-like groove 86. Among these two through holes, the through holes 88 communicated with the external ring-like groove 86 is connected to a means for supplying the solution A (such as a pump and connecting tube), while the through holes 87 communicated with the internal ring-like groove 85 is connected to a means for supplying the solution B (such as a pump and connecting tube). In Fig. 8, the microreactor is so designed that the solution A passes through the external ring-like groove 86, while the solution B passes through the internal ring-like groove 85, but this relation can likewise be reversed as well.

A circular combining (junction) hole 90 is formed at the center of the side 89 of the junction block 82 which is not opposed to the reaction block 83 and there are alternately and radially formed, starting from this combining hole 90, four long radial grooves 91, 91, 91, 91 and four short radial grooves 92, 92, 92, 92. These combining hole 90 and radial grooves 91, 92 form a circular space serving as the junction zone 90 and radial flow paths through which the solutions A and B flow, respectively when the microreactor device 80 is in its assembled state. In addition, there are formed through holes 95, 95, 95, 95 each of which extends from the tip of the long radial groove 91 among the 8 radial grooves 91, 92

to the direction of the thickness of the junction block 82 and these through holes 95 are connected to the external ring-like groove 86 formed on the supply block 81. At the same time, there are likewise formed through holes 96, 96, 96, 96 each of which extends from the tip of the short radial groove 92 to the direction of the thickness of the junction block 82 and these through holes 96 are connected to the internal ring-like groove 85 formed on the supply block 81.

In addition, a through hole 93 is formed, along the thickness thereof, at the center of the reaction block 83, it is connected to the junction hole 90 and this through hole 93 serves as a micro-flow path.

Thus, the solution A passes through the supply flow path comprising the through hole formed on the supply block 81, the external ring-like groove 86, the through hole 95 formed on the junction block 82 and the long radial groove 91, the solution A is divided into four branched streams and then it arrives at the junction zone (or the combining hole 90). On the other hand, the solution B passes through the supply flow path comprising the through hole 87 formed on the supply block 81, the internal ring-like groove 85, the through hole 96 formed on the junction block 82 and the short radial groove 92, the solution B is divided into four branched streams and then it arrives at the junction zone (or the combining hole 90). These branched solutions A and B, each of which has a corresponding kinetic energy, are combined together in the junction zone and flow into the micro-flow path while the running directions thereof is changed by 90 degrees.

Organic pigments used in the method for the preparation of a dispersion of organic pigment fine particles used in the present invention are not restricted in their hue and may be magenta, yellow or cyan pigments. Specific examples of the organic pigments usable herein include magenta, yellow or cyan pigments such as perylene type, perinone (pigment orange) type, quinacridone type, quinacridone quinone type, anthraquinone type, anthoanthrone type, benzimidazolone type, dis-azo condensed type, dis-azo type, azo type, indanthrone type, phthalocyanine type, triaryl carbonium type, dioxazine type, amino-anthraquinone type, diketo-pyrrolo-pyrrole type, thio-indigo type, iso-indoline type, iso-indolinone type, pyranthrone (pigment orange) type or iso-violanthrone (iso-vat blue) type pigments or mixture thereof.

More specifically, examples thereof include perylene type pigments such as C.I. Pigment Red 190 (C.I. No. 71140), C.I. Pigment Red 224 (C.I. No. 71127) and C.I. Pigment Violet 29 (C.I. No. 71129); perinone type pigments such as C.I. Pigment Orange 43 (C.I. No. 71105) or C.I. Pigment Red 194 (C.I. No. 71100); quinacridone type pigments such as C.I. Pigment Violet 19 (C.I. No. 73900), C.I. Pigment Violet 42, C.I. Pigment Red 122 (C.I. No. 73915), C.I. Pigment Red 192, C.I. Pigment Red 202 (C.I. No. 73907), C.I. Pigment Red 207 (C.I. No. 73900, 73906), or C.I. Pigment Red 209 (C.I. No. 73905); quinacridone quinone type pigments such as C.I. Pigment Red 206 (C.I. No. 73900/73920); C.I. Pigment Orange 48 (C.I. No. 73900/73920), or C.I. Pigment Orange 49 (C.I. No. 73900/73920); anthraquinone type pigments such as C.I. Pigment Yellow 147 (C.I. No. 60645); anthoanthrone type pigments such as C.I. Pigment Red 168 (C.I. No. 59300); benzimidazolone type pigments such as C.I. Pigment Brown 25 (C.I. No. 12510), C.I. Pigment Violet 32 (C.I. No. 12517), C.I. Pigment Yellow 180 (C.I. No. 21290), C.I. Pigment Yellow 181 (C.I. No. 11777), C.I. Pigment Orange 62 (C.I. No. 11775), or C.I. Pigment Red 185 (C.I. No. 12516); dis-azo condensed type pigments such as C.I. Pigment Yellow 93 (C.I. No. 20710), C.I. Pigment Yellow 94 (C.I. No. 20038), C.I. Pigment Yellow 95 (C.I. No. 20034), C.I. Pigment Yellow 128 (C.I. No. 20037), C.I. Pigment Yellow 166 (C.I. No. 20035), C.I. Pigment Orange 34 (C.I. No. 21115), C.I. Pigment Orange 13 (C.I. No. 21110), C.I. Pigment Orange 31 (C.I. No. 20050), C.I. Pigment Red 144 (C.I. No. 20735), C.I. Pigment Red 166 (C.I. No. 20730), C.I. Pigment Red 220 (C.I. No. 20055), C.I. Pigment Red 221 (C.I. No. 20065), C.I. Pigment Red 242 (C.I. No. 20067), C.I. Pigment Red 248, C.I. Pigment Red 262, or C.I. Pigment Brown 23 (C.I. No. 20060); dis-azo type pigments such as C.I. Pigment Yellow 13 (C.I. No. 21100), C.I. Pigment Yellow 83 (C.I. No. 21108), or C.I. Pigment Yellow 188 (C.I. No. 21094); azo type pigments such as C.I. Pigment Red 187 (C.I. No. 12486), C.I. Pigment Red 170 (C.I. No. 12475), C.I. Pigment Yellow 74 (C.I. No. 11714), C.I. Pigment Red 48 (C.I. No. 15865), C.I. Pigment Red 53 (C.I. No. 15585), C.I. Pigment Orange 64 (C.I. No. 12760), or C.I. Pigment Red 247 (C.I. No. 15915); indanthrone type pigments such as C.I. Pigment Blue 60 (C.I. No. 69800); phthalocyanine type pigments such as C.I. Pigment Green 7 (C.I. No. 74260), C.I. Pigment Green 36 (C.I. No. 74265), C.I. Pigment Green 37 (C.I. No. 74255), C.I. Pigment Blue 16 (C.I. No. 74100), C.I. Pigment Blue 75 (C.I. No. 74160:2), or C.I. Pigment Blue 15 (C.I. No. 74160); triaryl carbonium type pigments such as C.I. Pigment Blue 56 (C.I. No. 42800), or C.I. Pigment Blue 61 (C.I. No. 42765:1); dioxazine type pigments such as C.I. Pigment Violet 23 (C.I. No. 51319), or C.I. Pigment Violet 37 (C.I. No. 51345); amino-anthraquinone type pigments such as C.I. Pigment Red 177 (C.I. No. 65300); diketo-pyrrolo-pyrrole type pigments such as C.I. Pigment Red 254 (C.I. No. 56110), C.I. Pigment Red 255 (C.I. No. 561050), C.I. Pigment Red 264, C.I. Pigment Red 272 (C.I. No. 561150), C.I. Pigment Orange 71, or C.I. Pigment Orange 73; thio-indigo type pigments such as C.I. Pigment Red 88 (C.I. No. 73312); iso-indoline type pigments such as C.I. Pigment Yellow 139 (C.I. No. 56298), or C.I. Pigment Orange 66 (C.I. No. 48210); iso-indolinone type pigments such as C.I. Pigment Yellow 109 (C.I. No. 56284), or C.I. Pigment Orange 61 (C.I. No. 11295); pyranthrone type pigments such as C.I. Pigment Orange 40 (C.I. No. 59700) or C.I. Pigment Red 216 (C.I. No. 59710); or iso-violanthrone (iso-vat blue) pigments such as C.I. Pigment Violet 31 (C.I. No. 60010).

Preferred examples of organic pigments include quinacridone type pigments, diketo-pyrrolo-pyrrole type pigments, dis-azo condensed type pigments, or phthalocyanine type pigments. In this connection, particularly preferably used herein are quinacridone type pigments, dis-azo condensed type pigments or phthalocyanine type pigments.

Organic pigments used for preparing a dispersion of organic pigment fine particles according to the present invention may be one or at least two of the foregoing pigments, a solid solution thereof or any combination of an organic pigment and an inorganic pigment.

A solution (a) of an organic pigment (an alkaline or acidic solution obtained by dissolving an organic pigment in a solvent) used for preparing a dispersion of organic pigment fine particles is preferably one containing the organic pigment uniformly dissolved therein, but the method for the preparation of the same is not restricted to any specific one and accordingly, the solution may be prepared by directly dissolving a pigment in a solvent without using any additive; dissolving it in an alkaline or acidic aqueous solvent; or dissolving it in an aqueous solvent while separately adding an alkaline or acidic additive. The uniformity or solubility of a specific organic pigment in an acidic solvent may be compared with that of the pigment in an alkaline solvent to thus determine whether the pigment should be dissolved in an acidic solvent or an alkaline solvent to prepare a desired organic pigment solution. In this respect, alkaline conditions can in general be used for the dissolution of a pigment which has, in the molecule, alkali-dissociable groups, while acidic conditions can in general be used for the dissolution of a pigment which is free of any alkali-dissociable group and has, in the molecule, a large number of nitrogen atoms having a high affinity for protons. For instance, the quinacridone type pigments, the diketo-pyrrolo-pyrrole type pigments and the dis-azo condensed type pigments can be uniformly dissolved under alkaline conditions, while the phthalocyanine type pigments can more uniformly be dissolved under acidic conditions.

Examples of bases used for the dissolution of organic pigment under alkaline conditions include inorganic bases such as sodium hydroxide, potassium hydroxide, calcium hydroxide, or barium hydroxide; or organic bases such as trialkyl-amine, diazabicyclo-undecene (DBU), metal alkoxides ($NaOCH_3$, $KOC_2H_5$). Preferably used herein are inorganic bases.

The amount of such a base used is one required for uniformly dissolving each specific pigment and is not restricted to any specific one, but it preferably ranges from 1.0 to 30 molar equivalents, more preferably 2.0 to 25 molar equivalents and particularly preferably 3.0 to 20 molar equivalents with respect to the pigment used, in case of the inorganic base. On the other hand, it preferably ranges from 1.0 to 100 molar equivalents, more preferably 5.0 to 100 molar equivalents and further preferably 20 to 100 molar equivalents with respect to the pigment used, in case of the organic base.

The acid used when the pigment is dissolved under acidic conditions may be, for instance, an inorganic acid such as sulfuric acid, hydrochloric acid or phosphoric acid; or an organic acid such as acetic acid, trifluoroacetic acid, oxalic acid, methanesulfonic acid, or trifluoro-methanesulfonic acid, inorganic acids can preferably be used herein and sulfuric acid is more preferably used.

The amount of such an acid used is one required for uniformly dissolving each specific pigment and is not restricted to any specific one, but it is used in excess as compared with the base. It preferably ranges from 3 to 500 molar equivalents, more preferably 10 to 500 molar equivalents and particularly preferably 30 to 200 molar equivalents with respect to the pigment used, irrespective of whether the acid is inorganic or organic.

The aqueous medium (b) will now be described in more detail below. The term "aqueous medium" used herein means pure water or a mixed solvent comprising water and a water-soluble organic solvent. For instance, the organic solvent is herein used when the use of only water is insufficient for uniformly dissolving a pigment and/or a dispersant; when the use of only water is insufficient for obtaining a desired viscosity value required for circulating the resulting pigment solution through the flow path; or when any organic solvent should be used for forming laminar flows. In most of cases, the addition of a water-soluble organic solvent to an aqueous medium would permit the more uniform dissolution of, for instance, an organic pigment.

Examples of such organic solvents usable herein are polyhydric alcohols represented by ethylene glycol, propylene glycol, diethylene glycol, polyethylene glycol, thio-diglycol, dithio-diglycol, 2-methyl-1,3-propanediol, 1,2,6-hexanetriol, acetylene glycol derivatives, glycerin or trimethylol propane; lower mono-alkyl ether type solvents of polyhydric alcohols such as ethylene glycol monomethyl (or ethyl) ether, diethylene glycol monomethyl (or ethyl) ether, or triethylene glycol mono-ethyl (or butyl) ether; polyether type solvents such as ethylene glycol dimethyl ether (monoglyme), diethylene glycol dimethyl ether (diglyme), or triethylene glycol dimethyl ether (triglyme); amide type solvents such as dimethyl- formamide, dimethylacetamide, 2-pyrrolidone, N -methyl-2-pyrrolidone, 1,3-dimethyl-2- imidazolidinone, urea, or tetramethyl urea; sulfur atom-containing solvents such as sulfolane, dimethylsulfoxide, or 3-sulfolene; polyfunctional solvents such as di-acetone alcohol, diethanol-amine; carboxylic acid type solvents such as acetic acid, maleic acid, docosahexaenoic acid, trichloro-acetic acid, or trifluoro-acetic acid; and sulfonic acid type solvents such as methanesulfonic acid, or trifluoro-sulfonic acid. These solvents may be used in combination with at least two of them.

Organic solvents preferably used herein are amide type solvents or sulfur atom-containing solvents when the pigment is dissolved under alkaline conditions, while carboxylic acid type solvents, sulfur atom-containing solvents or sulfonic acid type solvents are preferably used when the pigment is dissolved under acidic conditions, and organic solvents more preferably used herein are sulfur atom-containing solvents for the former case, and sulfonic acid type solvents for the latter case. Particularly preferably used herein are dimethylsulfoxide (DMSO) (alkaline) and methanesulfonic acid (acidic).

The mixing ratio of water and an organic solvent is not restricted to specific one, inasmuch as it is suitable for the uniform dissolution of an organic pigment, but it preferably ranges from 0.05 to 10 (the ratio: water/organic solvent by mass) in case of the alkaline solvent. When the pigment is dissolved under acidic conditions and an inorganic acid is used, it is preferred not to use any organic solvent and, for instance, a sulfuric acid solution is preferably used alone. On the other hand, when using an organic acid, the organic acid per se serves as an organic solvent and accordingly, the viscosity of the resulting solution and the solubility of an organic pigment to be dissolved can, for instance, be controlled by the use of a plurality of acids or by the addition of water. Preferably, the mixing ratio (water/organic solvent (organic acid)) ranges from 0.005 to 0.1 (the ratio by mass). When the organic pigment solution (a) and the aqueous medium (b) are blended and brought into contact with one another using a flow path in the method for the preparation of a dispersion of organic pigment fine particles, it is preferred that a solution of an organic pigment uniformly dissolved therein is introduced into the flow path. In this respect, if a suspension of an organic pigment is introduced into the flow path, the pigment fine particles have an increased particle size and/or a wider particle size distribution and accordingly, the flow path may sometimes be clogged. In the present invention, the term "uniformly dissolved (uniform dissolution of an organic pigment)" means such a condition that a solution of a pigment is almost free of any turbidity or almost transparent when the solution is observed while irradiating the same with visible light rays and more specifically, the uniformly dissolved solution herein means a solution obtained by passing through a microfilter having a pore size of not more than 1 μm, or a solution free of any substance which can filtered off when it is passed through a filter having a pore size of not more than 1 μm.

Then the hydrogen ion exponent (pH) will be detailed below. The hydrogen ion exponent (pH) is a common logarithmic value of the reciprocal value of the hydrogen ion concentration (molar concentration) and sometimes also referred to as "hydrogen exponent". The term "hydrogen ion concentration" herein used means the concentration of hydrogen ions ($H^+$) present in a solution and more specifically, the molar number of hydrogen ions present in one liter of a solution. The hydrogen ion concentration may vary over a wide range and therefore, it is generally expressed in terms of the hydrogen ion exponent (pH). For instance, pure water contains hydrogen ions in an amount of $10^{-7}$ mole at 1 atm and 25°C and therefore, the pure water is neutral and the pH value thereof is defined to be 7. Aqueous solutions having a pH value of less than 7 are acidic, while those having a pH value of higher than 7 are alkaline. There have been known, as the method for determining pH, for instance, the potentiometric pH-determining technique and the colorimetric pH-determining technique.

When the organic pigment solution (a) and the aqueous medium (b) are blended and brought into contact with one another using a flow path in the method for the preparation of a dispersion of organic pigment fine particles, the hydrogen ion exponent (pH) can be changed during the step for passing the solutions through the flow path to thus form pigment fine particles, and this method can be carried out using a flow path an additional introducing port other than that for the introduction of the uniform solution of the organic pigment, or a flow path provided with at least two introducing ports such as those disclosed in Fig. 1A or Fig. 2A. In this case, the uniform solution (a) of the organic pigment is introduced into the flow path through the introducing port 11 described in Fig. 1A or the introducing port 21 described in Fig. 2A, while introducing, into the flow path, an aqueous medium (b) such as acidic or alkaline water, optionally comprising a dispersant and selected depending on the pH value of the solution (a) of the organic pigment or an aqueous solution, through the introducing port 12 described in Fig. 1A or the introducing port 22 described in Fig. 2A. Thus, both of these liquids can be brought into contact with one another within the flow path 13c or 23c and the hydrogen ion concentration or the hydrogen ion exponent (pH) of the solution containing the organic pigment can be changed towards the neutral region (pH 7). When using a flow path having an equivalent diameter of micron-size, the Reynolds number is small. Accordingly, a stable laminar flow can be formed (a cylindrical laminar flow in case of the flow path as shown in Fig. 2A) and the hydrogen ion exponent (pH) of the solution containing the organic pigment can gradually be shifted towards the neutral region by making water and/or ions move and diffuse through the stable interface formed between these two liquid phases. In this connection, it would be recognized that the pigment is hardly soluble in an aqueous medium around the neutral pH region. For this reason, the pigment can thus be gradually precipitated in the form of fine particles as the hydrogen ion exponent (pH) of the solution containing the organic pigment is shifted towards the neutral region.

When preparing pigment fine particles starting from a solution of a pigment in an alkaline aqueous medium, the variation of the hydrogen ion exponent (pH) thereof roughly falls within the pH range of from 16.0 to 5.0 and preferably 16.0 to 10.0. On the other hand, when preparing pigment fine particles starting from a solution of a pigment in an acidic aqueous medium, the hydrogen ion exponent (pH) thereof may roughly vary within the range of from 1.5 to 9.0 and preferably 1.5 to 4.0. The magnitude (width) of the pH variation is dependent upon the hydrogen ion exponent (pH) of each particular organic pigment solution used, but it is not restricted to any particular level insofar as the width is sufficient for promoting or accelerating the separation of the organic pigment.

The pigment fine particles formed within the micro-flow path never undergo any diffusion and flow through the path towards the discharge port while being maintained in the one laminar flow and therefore, the laminar flow containing

the organic pigment fine particles thus formed can be isolated by the use of a device provided with a flow path having such a discharge port as shown in Fig. 3A or Fig. 4. The use of this method is quite advantageous since the method would permit, at the same time, the preparation of a concentrated pigment dispersion and the removal of the water-soluble organic solvent used for forming a uniform pigment solution, the alkaline or acidic water, and any excess dispersant. Moreover, the method can prevent, for instance, the formation of coarse crystals and any quality change of the resulting pigment crystals due to the ultimate mixing of these two liquids.

The reaction temperature used for the preparation of organic pigment fine particles desirably falls within the range in which the solvent used never undergoes any solidification or vaporization, but it preferably ranges from -20 to 90°C, more preferably 0 to 50°C and particularly preferably 5 to 15°C.

The velocity (flow rate) of the fluid within the flow path preferably ranges from 0.1 mL/hr to 300 L/hr, more preferably 0.2 mL/hr to 30 L/hr, still further preferably 0.5 mL/hr to 15 L/hr and particularly preferably 1.0 mL/hr to 6 L/hr.

In the present invention, the concentration of the substrate (such as the organic pigment or the component reactive therewith), in general, ranges from 0.5 to 20% by mass and preferably 1.0 to 10% by mass.

In the method for preparing a dispersion of organic pigment fine particles, it is preferred to use an organic pigment solution and/or an aqueous medium, which comprises a polymerizable compound incorporated therein. More specifically, such a polymerizable compound is preferably incorporated into at least one of the organic pigment solution and/or the aqueous medium and more preferably, the compound is added to the organic pigment solution.

The polymerizable compound shows (1) an effect of being immediately adsorbed on the surface of separated pigment particles to thus form fine pigment particles and (2) an effect of preventing the occurrence of any secondary agglomeration of these pigment particles.

Moreover, in the method for preparing a dispersion of organic pigment fine particles, the organic pigment is separated from the solution thereof in the form of fine particles thereof, while the polymerizable compound present therein is polymerized in the dispersion and accordingly, quite high dispersion stability of the resulting pigment fine particles can be ensured in the dispersion. The working-effect of this behavior would be considered to be as follows: A polymerizable compound is present during the process for separating a pigment from a solution containing the same, in the form of fine particles thereof and the compound is thus immediately adsorbed on the separated fine particles so that the latter is effectively and completely surrounded by or enclosed with a layer of the polymerizable compound. For this reason, the polymerizable compound is adsorbed on the pigment fine particles in such a state which can never be obtained when pigment fine particles are simply blended with such a polymerizable compound. The polymerizable compound can certainly be polymerized, in situ, such that the polymerizable compound accurately covers the whole surface of the resulting pigment fine particles and preferably the compound can firmly and uniformly be immobilized on the surface thereof so as not to be released therefrom. In particular, when the polymerizable compound is a polymerizable surfactant, it can more strongly be adsorbed onto the surface of the resulting pigment fine particles and certainly surround the fine particles and therefore, the polymerizable surfactant would show a higher stabilization effect. Thus, the use of the polymerizable compound according to the present invention would allow the compound in the pigment fine particle dispersion to simultaneously show a size-control function upon the building up of the fine particles and the subsequent encapsulating function. Accordingly, the organic pigment in the finely dispersed particulate state can be encapsulated without any additional treatment and thus high dispersion stability and high storage stability can be imparted to the nano-sized pigment fine particles having a uniform particle size.

The organic pigment fine particle dispersion or the organic pigment fine particles prepared according to the present invention comprise a polymer formed from such polymerizable compound, immobilized on the pigment fine particles. The term "immobilization" used in the present invention means such a condition that all (or a part) of the molecules of the polymerizable compound present come in close contact with the pigment fine particles in the form of a homopolymer (or a copolymerized condition). At this stage, it is sufficient that the polymer may be present either on the surface of the pigment fine particles or in the fine particles and the whole polymer molecules (or a part thereof) are brought into close contact with the pigment fine particles. In addition, the polymer is preferably adhered to the fine particles so as not to be removed therefrom even when the particles migrate in the dispersion. In this respect, the term "polymer" used herein means a compound generated as a result of the polymerization of reaction of at least two molecules of the polymerizable compound, but all the molecules of the polymerizable compound present on the fine particles do not necessarily take part in the polymerization and the resulting dispersion may comprise unreacted polymerizable compound to a certain extent.

The polymerizable compound usable herein may be either or both of water-soluble and water-insoluble polymerizable compounds and may be any one inasmuch as it can be dispersed in the foregoing medium together with an organic pigment, but preferably used herein include ethylenically unsaturated monomers. Specific examples thereof include (meth)acrylic acid esters (such as methyl acrylate, ethyl acrylate, butyl acrylate, benzyl acrylate, 2-ethylhexyl acrylate, phenyl acrylate, cyclohexyl acrylate, methyl methacrylate, ethyl methacrylate, butyl methacrylate, hexyl methacrylate, 2-ethylhexyl methacrylate, octyl methacrylate, cyclohexyl methacrylate, ethyl β-hydroxyacrylate, propyl γ-amino- acrylate, propyl γ-hydroxyacrylate, butyl δ-hydroxyacrylate, ethyl β -hydroxy- methacrylate, stearyl methacrylate,

dimethyl-aminoethyl methacrylate, diethylene glycol methyl methacrylate, ethylene glycol ethyl dimethacrylate, tetraethylene glycol methyl dimethacrylate, and derivatives thereof); vinyl aromatic monomers (such as styrene, o-methylstyrene, m-methylstyrene, p-methylstyrene, p-methoxy-styrene, p-phenyl-styrene, p-chlorostyrene, p-ethylstyrene, p-butylstyrene, p-t-butylstyrene, p-hexyl-styrene, p-octyl- styrene, p-nonyl-styrene, p-decyl-styrene, p-dodecyl-styrene, 2,4-dimethyl-styrene, 3,4-di-chloro-styrene, α-methyl-styrene, divinyl-benzene, divinyl-naphthalene, and derivatives thereof); vinyl esters (such as vinyl acetate, vinyl propionate, vinyl benzoate, and derivatives thereof); N-vinyl-amides (such as N-vinyl-pyrrolidone); (meth)acrylic acid amides; alkyl-substituted (meth)acrylic acid amides; methacrylic acid amides; N-substituted maleimides; vinyl ethers (such as vinyl methyl ether, vinyl ethyl ether, vinyl isobutyl ether, vinyl phenyl ether, divinyl ether, and derivatives thereof); olefins (such as ethylene, propylene, isobutylene, 1-butene, 1-pentene, 4-methyl-1-pentene, butadiene, isoprene, chloroprene, and derivatives thereof); di-allyl phthalate, maleic acid anhydride, (meth)acrylonitrile, methyl vinyl ketone, and vinylidene chloride.

In addition, usable herein likewise include, for instance, water-soluble monomers having anionic groups such as sulfonate, phosphate, and carboxylate groups and specific examples thereof are monomers each having a carboxyl group such as acrylic acid, methacrylic acid, maleic acid, fumaric acid, itaconic acid and p-vinyl benzoate; and salts thereof such as alkali metal salts, alkaline earth metal salts, ammonium salts and amine salts. Furthermore, specific examples thereof also include styrene sulfonic acid, styrene sulfonic acid sodium salt, 2-acrylamido-2-methylpropanesulfonic acid, 2-hydroxymethyl methacryloyl-phosphate, 2-hydroxyethyl methacryloyl-phosphate and 3-chloro-2-hydroxy- propyl methacryloyl-phosphate. These monomers may be used alone or in any combination.

Among the foregoing polymerizable compounds, one having hydrophilic and hydrophobic functions at the same time is referred to as a polymerizable surfactant, a reactive surfactant or a reactive emulsifier, and it may preferably be used in the preparation of the dispersion of organic pigment fine particles according to the present invention. Examples thereof include those each having an α, β -ethylenically unsaturated group such as a vinyl, allyl, propenyl or (meth) acryloyl group and a group capable of being dissociated into its ion such as a sulfonate group or a hydrophilic group such as an alkyleneoxy group. These polymerizable compounds are anionic or nonionic surfactants each having, in the molecule, at least one radical-polymerizable unsaturated bond, which are in general used in the emulsion polymerization.

In the method for the preparation of an organic pigment fine particle dispersion, such polymerizable surfactants may be used alone or in any combination of at least two of them, or any combination thereof with polymerizable compounds other than the polymerizable surfactants. Examples of such polymerizable surfactants preferably used herein are those commercially available from, for instance, Kao Corporation, Sanyo Chemical Industries, Ltd., Dai-Ichi Kogyo Seiyaku Co., Ltd., Asahi Denka Kogyo K.K., Nippon Emulsifiers Co., Ltd., and Nippon Oil and Fats Co., Ltd., and those disclosed in Section 1-3: Design of Fine Particles using Reactive Emulsifiers, appearing in "Biryushi-Huntai-no-Saisentan-Gijutu" (Most Advanced Fine Particles Powdered Bodies), 2000, pp. 23-31, Published by CMC Publishing Company.

Specific examples of such polymerizable surfactants will be listed below, but the present invention is not restricted to these specific examples at all:

[Compound 1] ADEKALIASOAP SE-10N available from Asahi Denka Kogyo K.K.

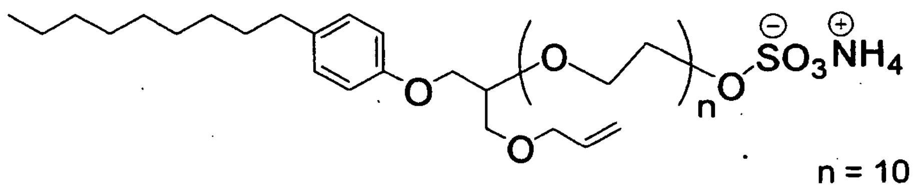

[Compound 2] ADEKA LIASOAP SR-10 available from Asahi Denka Kogyo K.K.

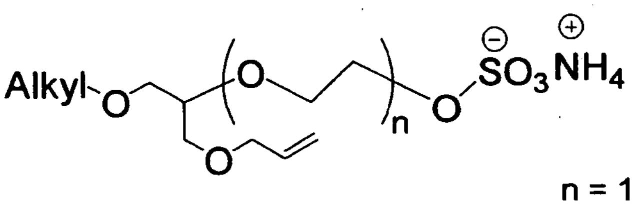

n = 10

[Compound 3] ADEKA LIASOAP NE-40 available from Asahi Denka Kogyo K.K.

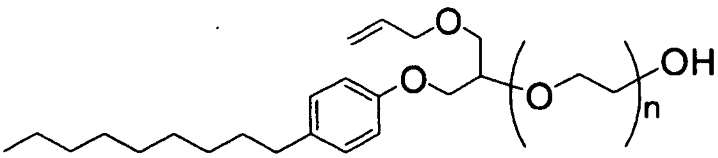

n = 40

[Compound 4] AQUALON HS-40 available from Dai-Ichi Kogyo Seiyaku Co., Ltd.

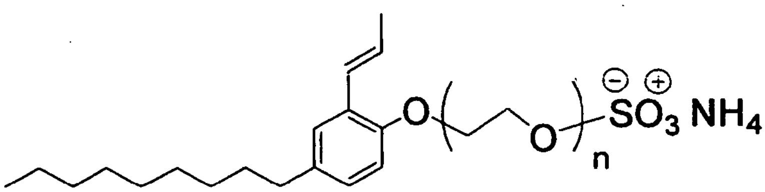

n = 40

[Compound 5] AQUALON KH-10 available from Dai-Ichi Kogyo Seiyaku Co., Ltd.

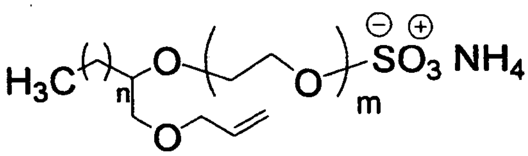

n=9 or 10, m=40

[Compound 6] TERAMUL S-180A available from Kao Corporation

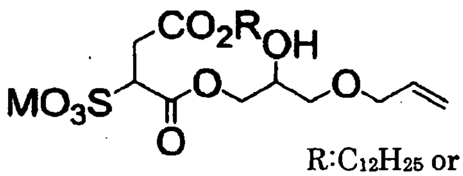

R: $C_{12}H_{25}$ or $C_{18}H_{36}F$
M: $NH_4$

[Compound 7] ELEMINOL JS-2 available from Sanyo Chemical Industries, Ltd.

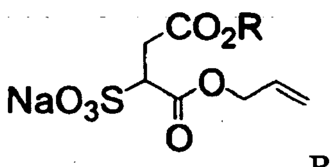

R: $C_{12}H_{25}$ etc.;

[Compound 8] Antox MS-60 available from Nippon Emulsifiers Co., Ltd.

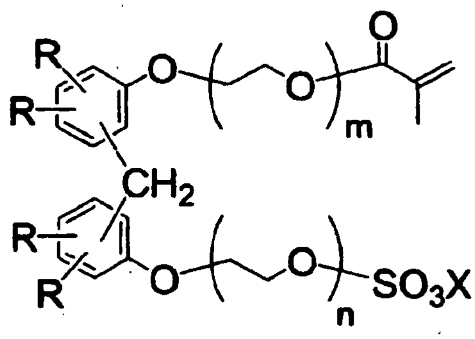

R: hydrogen atom, alkyl group, benzyl group or styrene group
X: alkali metal, alkali earth metal, ammonium cation, or amine cation
m is an integer of 1 or more
n is an integer of 1 or more

The content of the polymer formed from the polymerizable compound preferably ranges from 0.1 to 1000 parts by mass per 100 parts by mass of the pigment in order to further improve the uniform dispersibility of the pigment and the storage stability of the resulting pigment fine particle dispersion. The content thereof more preferably ranges from 1 to 500 parts by mass and particularly preferably 10 to 250 parts by mass per 100 parts by mass of the pigment. This is because the use of the polymerizable compound in a content of less than 0.1 part by mass never results in the sufficient improvement of the dispersion stability of the resulting organic pigment fine particles in the dispersion.
It is preferred that the content of the polymer formed from the polymerizable compound falls within the range of from 80 to 400 parts by mass and more preferably 100 to 250, based on 100 parts by mass of the pigment used, in order to obtain organic pigment fine particles, wherein the volume average particle size: Mv of the organic pigment fine particles is not more than 50 nm, and the ratio: Mv/Mn (wherein Mv represents the volume average particle size of the organic pigment fine particles and Mn represents the number average particle size of the same particles) ranges from 1 to 1.5.
The method for polymerizing the polymerizable compound used in the method for preparing an organic pigment fine particle dispersion is not restricted to any specific one inasmuch as the compound can be polymerized in the organic pigment fine particle dispersion, but preferably used herein are radical polymerization methods which make use of a polymerization initiator as the source of such radicals. There have been known a variety of means for initiating the polymerization of the compound, but preferably used herein are heat, light rays, ultrasonic waves and microwaves.

Usable herein as the polymerization initiator include, for instance, water-soluble or oil-soluble persulfates, peroxides and azo type compounds. Specific examples thereof are ammonium persulfate, potassium persulfate, sodium persulfate, hydrogen peroxide, t-butyl hydroperoxide, 2,2'-azo-bis-isobutyronitrile, 2,2'-azo-bis-(2-amidinopropane) di-hydrochloride, 2,2'-azo-bis-(2-N- benzyl-amidinopropane) di-hydrochloride, 2,2'-azo-bis-[2-N-(2-hydroxyethyl) amidino- propane] di-hydrochloride, and a various kinds of water-soluble azo type polymerization initiators, oil-soluble azo type polymerization initiators, and polymeric azo type polymerization initiators are disclosed in, for instance, the home page of WAKO Pure Chemical Co., Ltd. (www. Wako-chem. Co. jp) along with the 10 hour-half life temperatures and the chemical structures thereof and accordingly, they are available from the same company. The amount of the polymerization initiator to be added is not restricted to any specific one, but it preferably ranges from 0.1 to 30% by mass, more preferably 1 to 20% by mass and particularly preferably 2 to 10% by mass on the basis of the mass of the total monomer components.

In the method for the preparation of an organic pigment fine particle dispersion, the polymerizable compound may be polymerized, in the dispersion, in the coexistence of another monomer copolymerizable with the former to thus copolymerize them. The time at which the copolymerizable monomer is incorporated into the dispersion is not particularly restricted, but it is preferred that at least one copolymerizable monomer is incorporated into at least one of the organic pigment solution and the aqueous medium. The copolymerizable monomer is not limited to any specific one insofar as it never obstructs the separation of fine particles and/or the stabilization of the resulting dispersion and accordingly, examples thereof include polymerizable compounds listed above.

In the method for preparing such an organic pigment fine particle dispersion, the time of the preparation process to polymerize the polymerizable compound and the method therefor are not particularly restricted, but the polymerization reaction may be carried out in the course or after the completion of the following step (1), or in the course or after the completion of the following step (2), or in the both of these steps, while taking the following steps by way of example:

(1) The step for blending a solution containing an organic pigment dissolved therein and an aqueous medium;
(2) The step for concentrating and purifying the dispersion obtained after the foregoing blending step.

Regarding the polymerization initiator, the time of the preparation process to add the same to the dispersion and the method therefor are not likewise particularly restricted, but, they may, for instance, be carried out according to either of the following four embodiments or any combination thereof:

(1) It is added to a solution containing an organic pigment dissolved therein;
(2) It is added to an aqueous medium;
(3) The solution containing an organic pigment dissolved therein is blended with the aqueous medium and then the polymerization initiator is added to the resulting mixture;
(4) The dispersion obtained after the blending of the foregoing two liquids is concentrated and purified and then the polymerization initiator is added to the resulting concentrated and purified liquid.

In the method for preparing the organic pigment fine particle dispersion, the polymerizable compound is included in at least one of the organic pigment solution (a) and the aqueous medium (b), but the polymerizable compound is preferably included in the organic pigment solution (a). When simultaneously using another polymerizable compound and/or a dispersant, the mode of using the same is not restricted to any specific one, but they may be dissolved in either of the organic pigment solution and the aqueous medium, or they may likewise be incorporated into the dispersion obtained after the blending of these liquids. In addition, when precipitating pigment fine particles, a liquid other than the organic pigment solution or the aqueous medium may optionally be added insofar as the use thereof never impairs the intended effects of the present invention and at least three liquids may simultaneously or sequentially be admixed together.

The polymerization reaction temperature may properly be selected depending on the kind of polymerization initiator used and the polymerization reaction is preferably carried out at a temperature ranging from 40 to 100°C, more preferably 50 to 90°C and particularly preferably 50 to 80°C.

The polymerization reaction time may vary depending on, for instance, the kind of the polymerizable compound used, the concentration thereof and the reaction temperature of the polymerization initiator used, but the polymerization reaction may be carried out for a time period ranging from 1 to 12 hours.

In the method for preparing the organic pigment fine particle dispersion, a dispersant may further be incorporated into the dispersion. This is because, the addition of a dispersant would permit the further improvement of the following effects of the polymerizable compound: (1) an effect of being immediately adsorbed on the surface of separated pigment particles to thus form fine pigment particles and (2) an effect of preventing the occurrence of any secondary agglomeration of these pigment particles. The dispersant usable herein may be, for instance, anionic, cationic, amphoteric, nonionic or pigmentary dispersants each having a low or high molecular weight. These dispersants may be used alone or in any combination thereof. The dispersants usable for the dispersion of pigments are disclosed in detail in "Pigment Dispersion-Stabilization and Surface- Treating Technique · Evaluation", 2001 (Dec.), pp. 29-46 (Published by Society of Chemical

Information).

Examples of anionic dispersants (anionic surfactants) include N-acyl-N-alkyl-taurine salts, fatty acid salts, alkylsulfuric acid ester salts, alkylbenzene-sulfonic acid salts, alkyl- naphthalene-sulfonic acid salts, dialkylsulfo-succinic acid salts, alkyl-phosphoric acid ester salts, naphthalene-sulfonic acid/formalin condensates, and polyoxyethylene alkylsulfuric acid ester salts. Among these, preferably used herein are N-acyl-N-alkyl-taurine salts. Preferred examples of N-acyl-N-alkyl-taurine salts are those disclosed in J.P. KOKAI Hei 3-273067. These anionic dispersants may be used alone or in any combination of at least two of them.

Examples of cationic dispersants (cationic surfactants) include quaternary ammonium salts, alkoxylated polyamines, aliphatic amine polyglycol ethers, aliphatic amines, diamines and polyamines derived from aliphatic amines and aliphatic alcohols, imidazolines derived from fatty acids and salts of these cationic substances. These cationic dispersants may be used alone or in any combination of at least two of them.

Examples of amphoteric dispersants are those having, at the same time, anionic groups or moieties which are included in the foregoing anionic dispersants and cationic groups or moieties which are included in the foregoing cationic dispersants.

Examples of nonionic dispersants (nonionic surfactants) include polyoxyethylene alkyl ethers, polyoxyethylene alkylaryl ethers, polyoxyethylene fatty acid esters, sorbitan fatty acid esters, polyoxyethylene sorbitan fatty acid esters, polyoxyethylene alkylamines, and glycerin fatty acid esters. Among these, preferably used herein are polyoxyethylene alkylaryl ethers. These nonionic dispersants may be used alone or in any combination of at least two of them.

The term "pigmentary dispersant" herein used is defined to be a dispersant derived from an organic pigment as a parent substance and having such a parent structure which has chemically been modified and examples thereof include sugar-containing pigmentary dispersants, piperidyl-containing pigmentary dispersants, naphthalene- or perylene-derived pigmentary dispersants, pigmentary dispersants each having a functional group connected to its parent structure through a methylene group, pigmentary dispersants whose parent structures are chemically modified with polymers, pigmentary dispersants each having a sulfonate group, pigmentary dispersants each having a sulfonamide group, pigmentary dispersants each having an ether group, or pigmentary dispersants each having a carboxylate, carboxylic acid ester or carboxyamide group.

Specific examples of polymeric dispersants include polyvinyl pyrrolidone, polyvinyl alcohol, polyvinyl methyl ether, polyethylene oxide, polyethylene glycol, polypropylene glycol, polyacrylamide, vinyl alcohol-vinyl acetate copolymer, polyvinyl alcohol partially modified with formal, polyvinyl alcohol partially modified with butyral, vinyl pyrrolidone-vinyl acetate copolymer, polyethylene oxide/propylene oxide block copolymer, polyacrylic acid salts, polyvinyl sulfuric acid salts, poly(4-vinylpyridine) salts, polyamide, poly(allyl-amine), condensed naphthalene-sulfonic acid salts, styrene-acrylic acid salts, styrene-methacrylic acid salt copolymers, acrylic acid ester-acrylic acid salt copolymers, acrylic acid ester-methacrylic acid salt copolymers, methacrylic acid ester-acrylic acid salt copolymers, methacrylic acid ester-methacrylic acid salt copolymers, styrene-itaconic acid salt copolymers, itaconic acid ester-itaconic acid salt copolymers, vinyl naphthalene-acrylic acid salt copolymers, vinyl naphthalene-methacrylic acid salt copolymers, vinyl naphthalene-itaconic acid salt copolymers, cellulose derivatives, and starch derivatives. Other polymeric dispersants usable herein also include, for instance, naturally-occurring polymers such as alginic acid salts, gelatin, albumin, casein, gum arabic, tragacanth gum, and lignin sulfonic acid salts. Among them, preferably used herein are polyvinyl pyrrolidones. These polymers may be used alone or in any combination of at least two of them.

In the method for preparing the organic pigment fine particle dispersion, a various kinds of inorganic or organic functional additives may likewise be incorporated into the dispersion irrespective of whether they are polymerized or not. The time of the preparation process to incorporate such a functional additive into the dispersion is not particularly limited, but it is, for instance, preferred that the functional additive is incorporated into at least one of the organic pigment solution and the aqueous medium, in advance. The functional additive is not particularly limited insofar as it never obstructs the separation of fine particles and/or the stabilization of the resulting dispersion. Examples of such functional additives include sequestering agents, anti-bacterial agents, antifungal agents, perfumes, ultraviolet light ray-absorbers, antioxidants, surface tension-controlling agents, water-soluble resins, pH-adjusting agents, and urea.

It is also possible to simultaneously use additives such as ultraviolet light ray- absorbers, antioxidants, perfumes, antifungal agents, surface tension-controlling agents, water-soluble resins, anti-bacterial agents, pH-adjusting agents, and urea for the purpose of further improving the fastness of the pigment used. In this respect, the time of the preparation process to add these additives to the dispersion and the method therefor are not likewise particularly restricted, but, they may, for instance, be carried out according to either of the following four modes or any combination thereof:

(1) They are added to a solution containing an organic pigment dissolved therein;
(2) They are added to an aqueous medium;
(3) The solution containing an organic pigment dissolved therein is blended with the aqueous medium and then these additives are added to the resulting mixture;
(4) The dispersion obtained after the blending of the foregoing two liquids is concentrated and purified and then

these additives are added to the resulting concentrated and purified liquid.

In addition, various kinds of chain-transfer agents (such as catechols, alcohols, thiols, mercaptans) may likewise be used for the control of the degree of polymerization (molecular weight).

The content of the dispersant in the dispersion preferably ranges from 0.1 to 1000 parts by mass per 100 parts by mass of the pigment in order to further improve the uniform dispersibility of the pigment and the storage stability of the resulting pigment fine particle dispersion. The content thereof more preferably ranges from 1 to 500 parts by mass and particularly preferably 10 to 250 parts by mass per 100 parts by mass of the pigment. This is because the use of the dispersant in a content of less than 0.1 part by mass does not always result in the sufficient improvement of the dispersion stability of the resulting organic pigment fine particles in the dispersion.

In the method for preparing the organic pigment fine particle dispersion, the solvent used therein may be, for instance, organic solvents, dispersants, surfactants, polymerizable compounds, additives, or water, which have already been detailed and discussed above, and any combination thereof. Moreover, it is also possible to optionally add, for instance, water-soluble organic solvents and other components, which are commonly added to an ink composition. These solvent components may be, for instance, the constituents of the pigment dispersants as disclosed in J.P. KOKAI Nos. 2002-194263 and 2003-26972.

The fluids to be blended may be those miscible with one another or those mutually immiscible with one another. The fluids miscible with one another are, for instance, a couple of solutions prepared using the same organic solvent or organic solvents whose properties are relatively resemble with one another, or a combination of a solution prepared using an organic solvent having a high polarity such as methanol and water, while the fluids mutually immiscible with one another are, for instance, a combination of a solution prepared using an organic solvent having a low polarity such as hexane and a solution prepared using an organic solvent having a high polarity such as methanol.

When using gases such as air, nitrogen, oxygen, argon and/or helium gases, they may, for instance, be introduced into the reaction system in the form of a solution obtained by dissolving the same in a reactive fluid, or in their gaseous states. They are preferably introduced in their gaseous states.

According to the method for preparing the organic pigment fine particle dispersion, the organic pigment can be precipitated as fine particles, while the polymerizable compound can be polymerized so that the polymer film is preferably formed on the fine particles to thus immobilize the polymer film on the surface of the fine particles. More specifically, the method of the present invention does not require the use of any step for pulverizing fine particles or the removal of the resulting fine particles in order to switch the process facilities. This means the introduction of a continuous production method while making use of the flowing technique and this method would provide a variety of merits such as the quality stabilization of the resulting products, the process stabilization, and the substantial reduction of physical losses such as the time period and energy required, and any transportation of, for instance, intermediate products.

The pigment dispersion prepared according to the foregoing method for preparing the organic pigment fine particle dispersion may be subjected to purification, concentration and/or classification treatments by, for instance, filtration and/or centrifugal separation techniques prior to and/or after the polymerization treatment. Moreover, it is also possible to add, to the pigment dispersion, optional additives such as a solvent (a wetting agent, and/or other additives (such as a sequestering agent, an anti-bacterial agent, an anti-fungal agent, a perfume, a UV light absorber, an antioxidant, a surface tension- controlling agent, a water-soluble resin, a pH-controlling agent and urea) to thus adjust the physical properties of the liquid, depending on the final applications thereof.

The organic pigment fine particle dispersion of the present invention can be used as, for instance, a pigment for an ink composition and in this case, the dispersion of the present invention can be used after the purification and/or concentration thereof through, for instance, the centrifugal separation technique and/or the ultrafiltration technique. To the resulting pigment dispersion, there are added water-soluble high boiling organic solvents such as glycerins, and glycols; a pH controlling agent for the control of the pH value thereof which is adjusted to the level on the order of 7 to 9; and other additives for the control of the surface tension and viscosity of the product, and for the preservation, to thus prepare an ink jet recording ink composition. When the dispersion is used as an ink jet ink composition, the preferred viscosity thereof may vary depending on the kind of pigment used and the concentration thereof, but it is common that the viscosity thereof is preferably not more than 20 mPa · s, more preferably not more than 10 mPa · s, and particularly preferably not more than 5 mPa · s, at a pigment concentration of, for instance, 5% by mass.

In addition thereto, the pigment dispersion of the present invention can likewise widely used as, for instance, color filters, after subjecting it to appropriate treatments such as the foregoing separation, concentration and the control of the liquid physical properties.

(1-2) Photopolymerizable Compound

The photopolymerizable compound used in the composition of the present invention is a compound having an ethylenically unsaturated bond capable of undergoing radical polymerization and it is not restricted to any specific one

inasmuch as it has at least one ethylenically unsaturated bond capable of undergoing radical polymerization and examples thereof include those having such chemical forms as monomers, oligomers and polymers. These radical polymerizable compounds may be used alone or in any combination of at least two of them in any rate, for the improvement of the intended properties.

In addition, the compound having an ethylenically unsaturated bond capable of undergoing radical polymerization is preferably one having, in the molecule, at least one carboxyl group in addition to the foregoing ethylenically unsaturated bond and examples of such compounds are as follows:

(1) Reaction products of dibasic acid anhydrides with hydroxyl group-containing acrylic acid esters or methacrylic acid esters: Typical compounds thereof include, for instance, reaction products of acids such as succinic acid anhydride, o-phthalic acid anhydride and maleic acid anhydride with, for instance, 2-hydroxyethyl methacrylate and 3-chloro-2- hydroxypropyl methacrylate.

(2) Compounds obtained through the reaction of secondary hydroxyl groups present in acrylic acid ester of epoxy resins with dibasic acid anhydrides: Typical compounds thereof include, for instance, those obtained by reacting bisphenol type epoxy resins such as EPICOAT 828 and EPICOAT 1001 (trade name of products available from YUKA Shell Epoxy Co., Ltd.), polyhydric alcohol aliphatic epoxy resins such as DECONAL (trade name of products available from NAGASE Chemical Industries, Ltd.), for instance, 1,4-butanediol diglycidyl ether, trimethylol-propane diglycidyl ether and pentaerythritol triglycidyl ether, cyclic aliphatic epoxy resins such as CELLOXIDE (trade name of products available from DYCELL Chemical Co., Ltd.) with acrylic acid esters and then reacting the hydroxyl groups remaining on the resulting resins or newly formed thereon with succinic acid anhydride, maleic acid anhydride.

(3) Compounds obtained by reacting polyhydric alcohol esters of acrylic or methacrylic acid: Typical examples thereof are compounds prepared by reacting glycol or polyethylene glycol esters of acrylic acid with succinic acid anhydride, or maleic acid anhydride. The glycol or polyethylene glycol used herein is preferably those having a molecular weight of not more than about 600.

(4) Water-soluble urethane acrylates and methacrylates having carboxyl group-containing side chains in the molecule: The synthesis method of oligomers as UV-curable resins has been known. In the synthesis of an oligomer compound having carboxyl group- containing side chains, however, it is necessary to use trimellitic acid anhydride typical of the polybasic acid or dimethylol propionic acid typical of the compound having, in the molecule, two hydroxyl groups and a carboxyl group are used in the course of the synthesis of such an oligomer.

Further, the compounds (1) to (4) illustrated above can be converted into those easily soluble in water by the neutralization thereof with bases. Specific examples of such bases include ammonia, methylamine, ethylamine, dimethylamine, diethylamine, n-butylamine, di-n-butyiamine, trimethylamine, ethylenediamine, diethylenetriamine, triethylene- tetramine, tetraethyl-pentamine, propylenediamine, ethanolamine, hexylamine, laurylamine, diethanolamine, triethanolamine, morpholine, piperidine, propylamine, isopropyl- amine, isobutylamine, NaOH, LiOH, and KOH. In this respect, the use of an organic base is preferred for imparting chemical resistance against etching liquids to the UV-curable compound and for making it possible to peel off the film of the UV-curable compound from a substrate using a strong alkali. Particularly preferably used herein as such bases are highly volatile ones among others or preferably used are bases each having a boiling point of not more than 190°C as determined at ordinary pressure.

Moreover, the photopolymerizable compounds usable in the present invention may likewise be water-soluble radical polymerizable compounds. Examples of such compounds are those listed below, but the present invention is not restricted to these specific compounds at all:

(1) 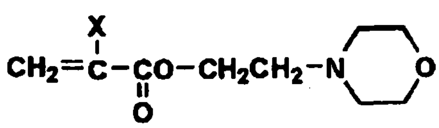 (2) 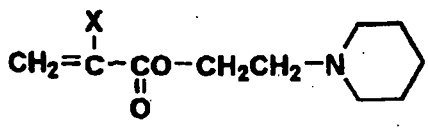

(3) 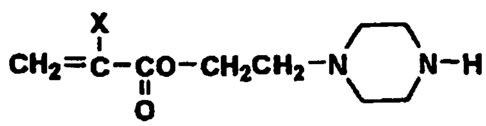

(4) 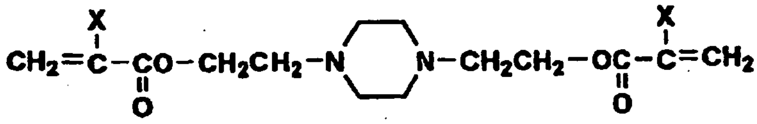

(5) 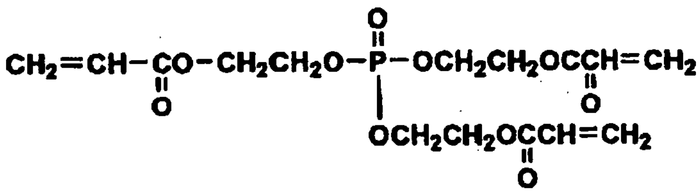

(6) $CH_2=CHCOOCH_2CH_2OOCCH_2CH_2COOH$

(7) $CH_2=CHCOO(CH_2CH_2COO)_n$-H (n is an integer ranging from 1 to 4)

(8) $CH_2=CHCOO(CH_5H_{10}COO)_n$-H (n is an integer ranging from 1 to 5)

(9) 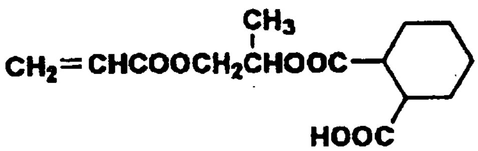

(10) 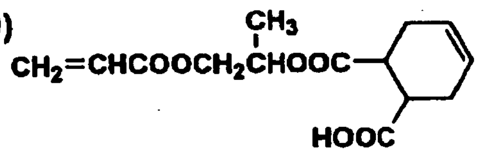

(11) 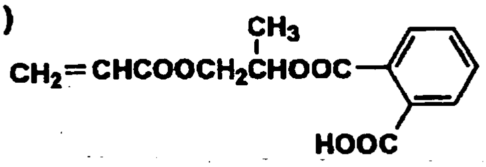

(12) 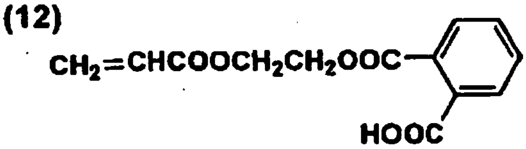

(13) 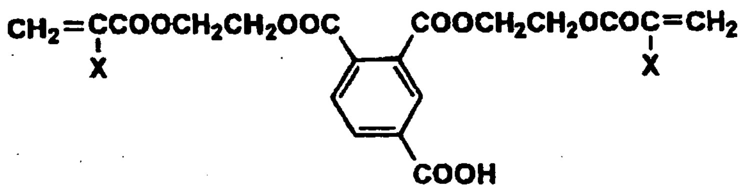

The symbol X appearing in the foregoing formulas (1) to (4) and (13) represents a hydrogen atom or a methyl group.

The polymerizable compounds which can be radical-polymerized by the irradiation with ultraviolet light rays are, for instance, water-soluble polymerizable compounds selected from those represented by the general formulas of Group A in which R represents a residue of a polyol or those represented by the general formulas of Group B in which R represents a residue derived from an epoxy ester of a polyol. In this connection, the general formulas of Group A and the general formulas of Group B will be detailed later.

$$[Z]_L\text{-}R\text{-}[A]_k$$

wherein, k is 2 or 3; L is 1 or 2; and Z represents $COO^-$ or a salt thereof. In addition, A represents a group: -CO-C(X)$=CH_2$ (X represents H or a methyl group).

The foregoing formula can more distinctly be depicted as follows: [$COO^-$ or salt thereof]$_L$-R-[CO-C(X)=$CH_2$]$_k$ wherein, k is 2 or 3; L is 1 or 2; and X represents H or a methyl group.

Further, preferably used herein as the substances represented by the general formulas of Group A are those listed below. In this connection, the symbols A, X, Rx, Ry, Rz and Rp appearing in the polymerizable substances of Groups A1 to A11 represented by the following general formulas independently represent the following atomic groups:

A: 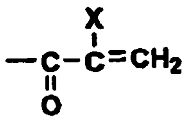 (X represents H or a methyl group)

Rx, Ry, Rz: $-(CH_2CH_2O)_{n1}-$ (the side bound to A)
(n1 = an integer ranging from 0 to 5);
or

$-(CH_2CH_2O)_{n2}-CH_2CH(OH)CH_2O-$ (the side bound to A)

(n2 = an integer ranging from 0 to 5).

(1-1)

($COO^-$ or salt thereof) 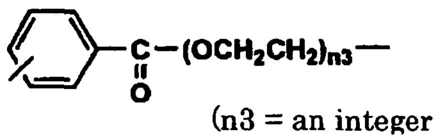

(n3 = an integer ranging from 0 to 5);

(1-2)

($COO^-$ or salt thereof) 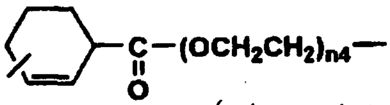

(n4 = an integer ranging from 0 to 5);

(1-3) ($COO^-$ or salt thereof) 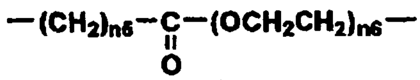

(n5 = an integer ranging from 2 to 6;
n6 = an integer ranging from 0 to 5)

(1-4)

($COO^-$ or salt thereof) 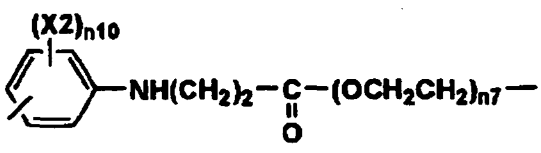

(n7 = an integer ranging from 0 to 5; n10 = an integer ranging from 1 to 4; X2 = a halogen atom, an alkoxy group or a nitro group)

(1-5)

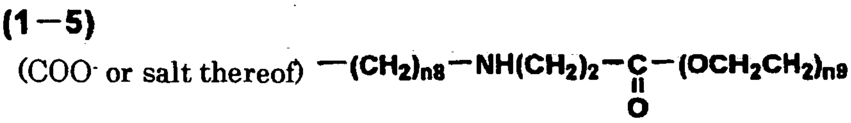

(n8 = an integer ranging from 1 to 6; n9 = an integer ranging from 0 to 5)

In this connection, the halogen atom represented by X2 appearing in the foregoing formula (1-4) which shows one of the structures of Rp may be, for instance, a fluorine, chlorine or bromine atom, and the alkoxy group likewise represented by X2 may be one having 1 to 3 carbon atoms.

First, the polymerizable compounds usable herein include those represented by the following general formula of Group A and more specifically, usable herein include polymerizable compounds A1-1 to A1-2 represented by the following formulas:

In addition, the polymerizable compounds usable herein also include those represented by the following general formula of Group A2 and more specifically, usable herein includes a polymerizable compound A2-1 represented by the following formula:

Polymerizable Compound Group A1

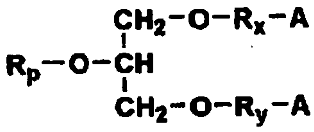

Polymerizable Compound Group A1-1

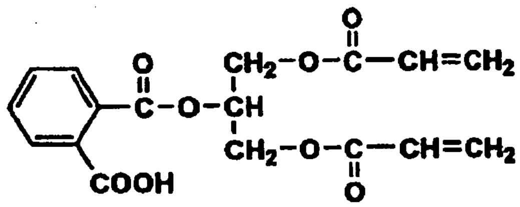

Polymerizable Compound Group A1-2

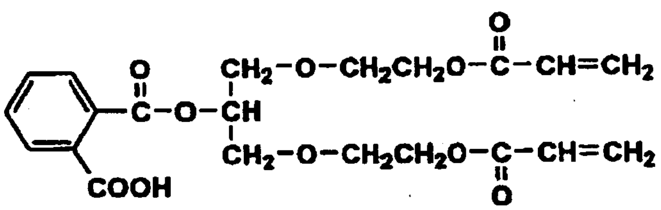

Polymerizable Compound Group A2

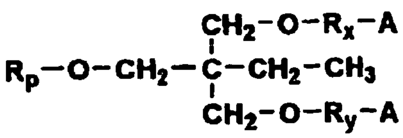

Polymerizable Compound Group A2-1

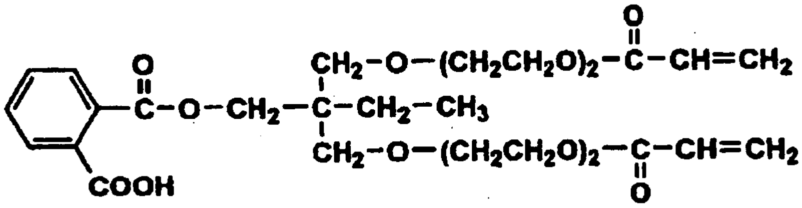

Further, the polymerizable compounds usable herein likewise include those represented by the following general formula of Group A3 and more specifically, usable herein include polymerizable compounds A3-1 to A3-4 represented by the following formulas:

Polymerizable Compound Group A3

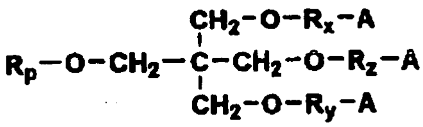

Polymerizable Compound Group A3-1

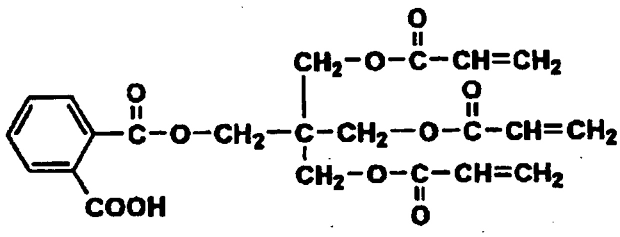

Polymerizable Compound Group A3-2

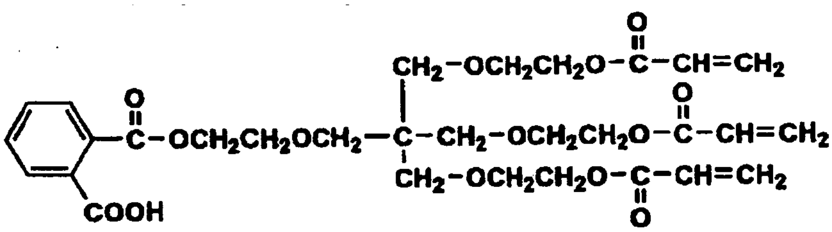

Polymerizable Compound Group A3-3

lymerizable Compound Group A3-3

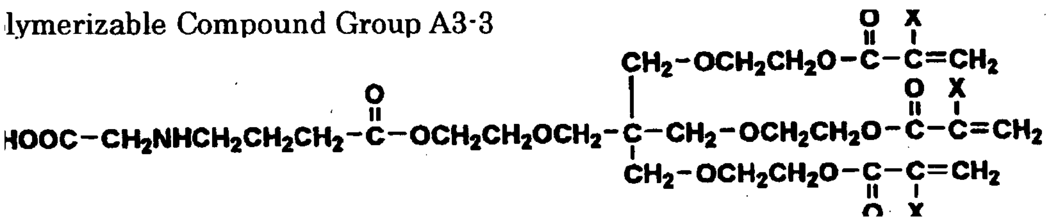

Polymerizable Compound Group A3-4

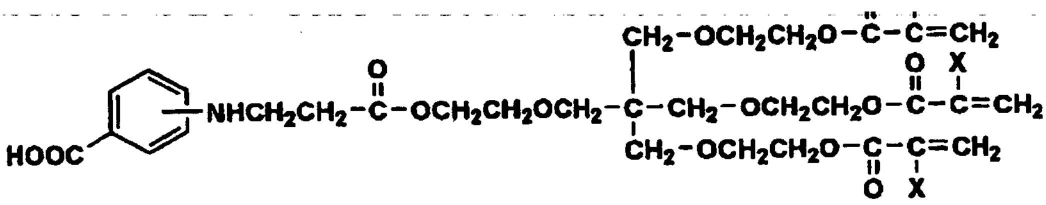

X: H or $CH_3$

In addition, the polymerizable compounds usable herein further include those represented by the following general formula of Group A4 and more specifically, usable herein includes a polymerizable compound A4-1 represented by the following formulas:

Polymerizable Compound Group A4

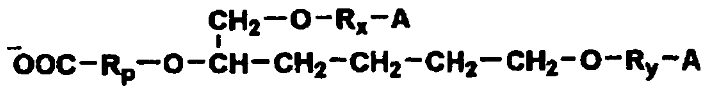

Polymerizable Compound Group A4-1

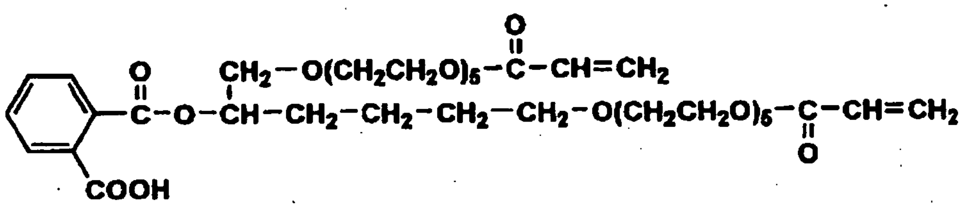

Moreover, the polymerizable compounds usable herein further include those represented by the following general formula of Group A5 and more specifically, usable herein includes a polymerizable compound A5-1 represented by the following formulas:

Polymerizable Compound Group A5

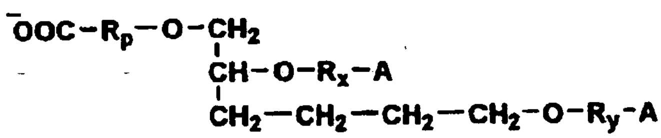

Polymerizable Compound Group A5-1

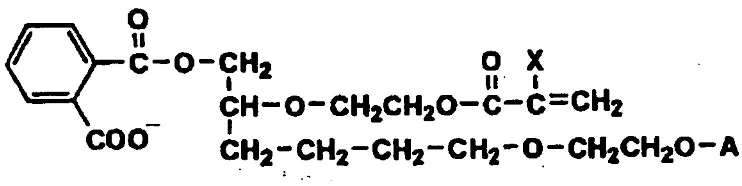

X: H or $CH_3$

Furthermore, the polymerizable compounds usable herein also include those represented by the following general formulas of Group A6 to Group A11:

Polymerizable Compound Group A6

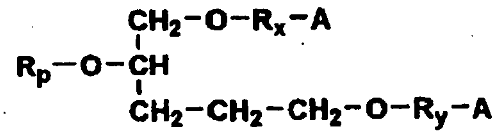

Polymerizable Compound Group A7

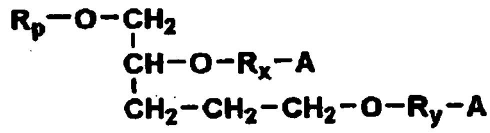

Polymerizable Compound Group A8

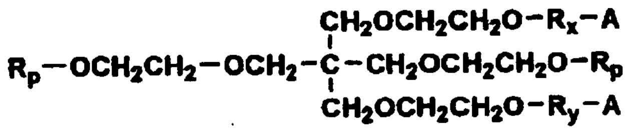

Polymerizable Compound Group A8-1

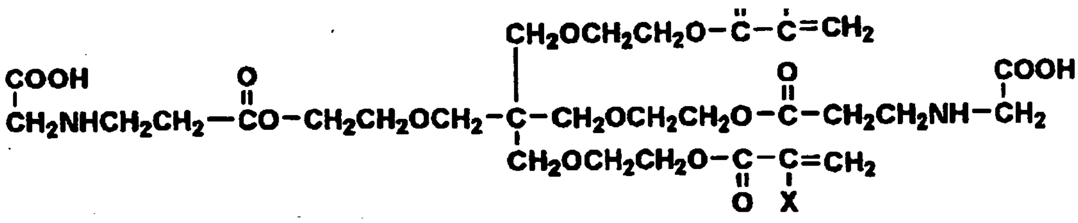

X: H or $CH_3$

Polymerizable Compound Group A8-2

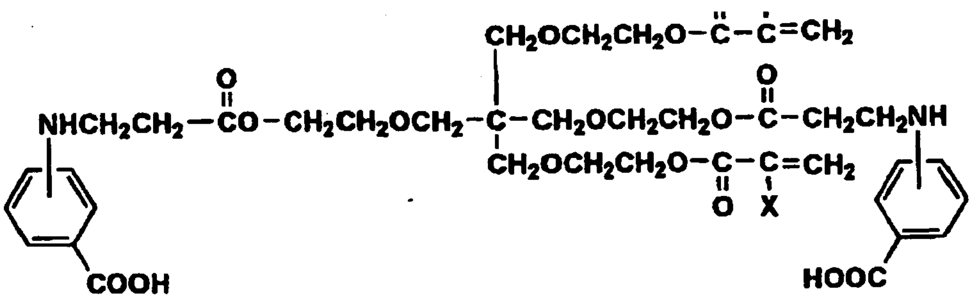

X: H or $CH_3$

Polymerizable Compound Group A9

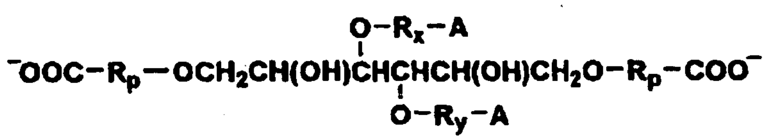

Polymerizable Compound Group A9-1

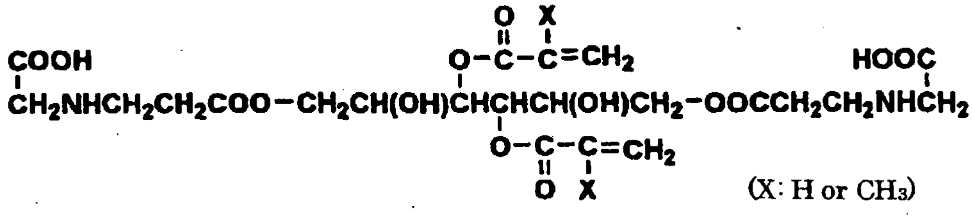

(X: H or $CH_3$)

Polymerizable Compound Group A9-2

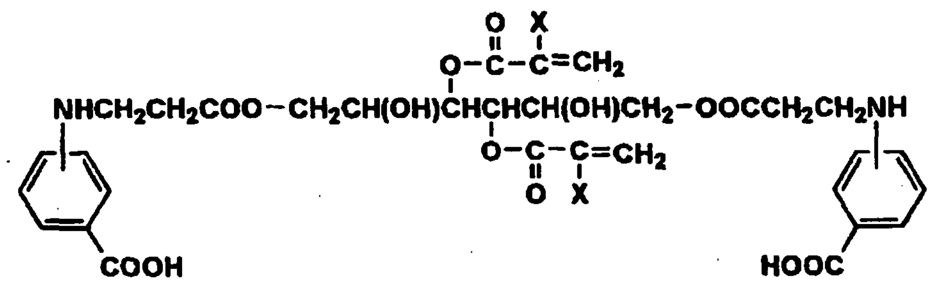

(X: H or $CH_3$)

Polymerizable Compound Group A10

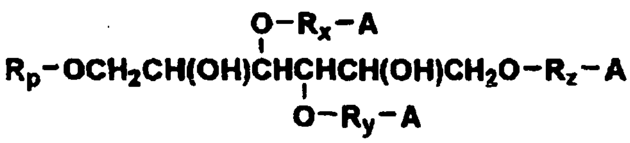

Polymerizable Compound Group A10-1

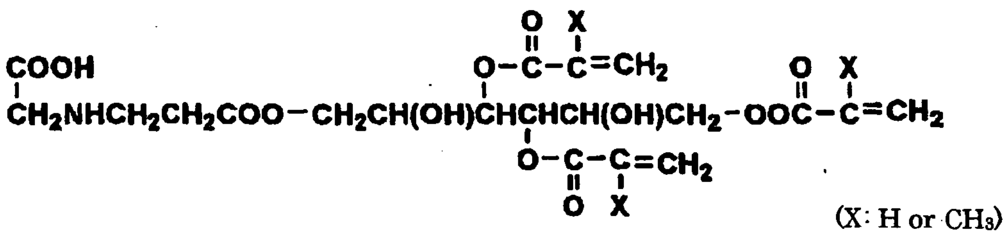

(X: H or $CH_3$)

Polymerizable Compound Group A10-2

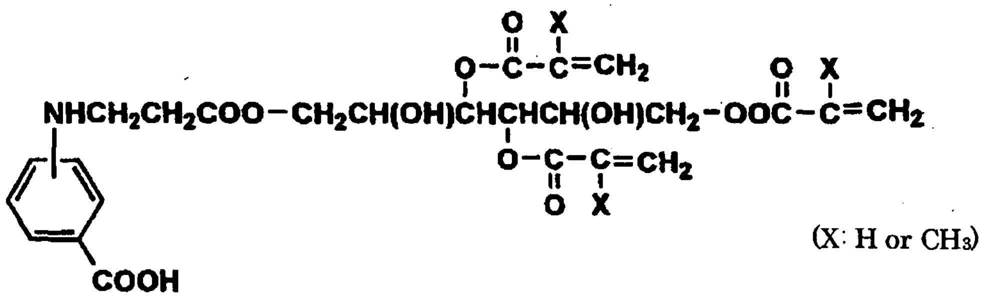

(X: H or $CH_3$)

Polymerizable Compound Group A11

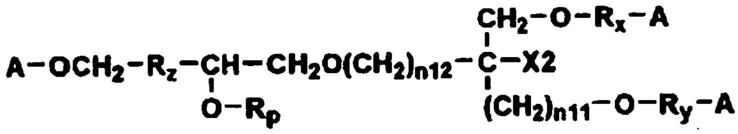

($X2 = H$, $CH_3$ or $C_2H_5$;
n11 = an integer ranging from 1 to 5;
n12 = 0 or 1)

Polymerizable Compound Group A11-1

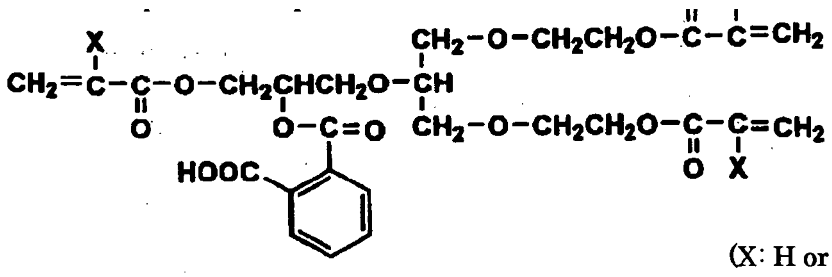

(X: H or $CH_3$)

Polymerizable Compound Group A11-2

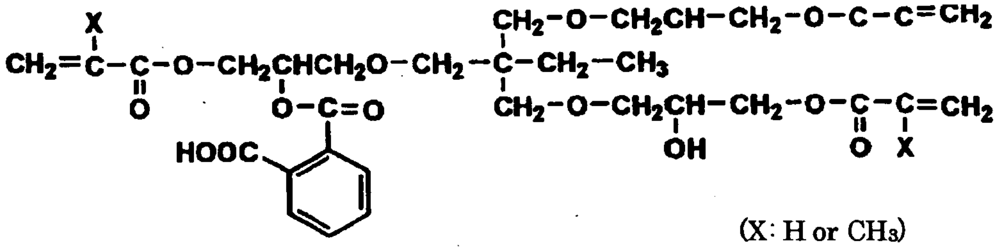

(X: H or $CH_3$)

Polymerizable Compound Group A11-3

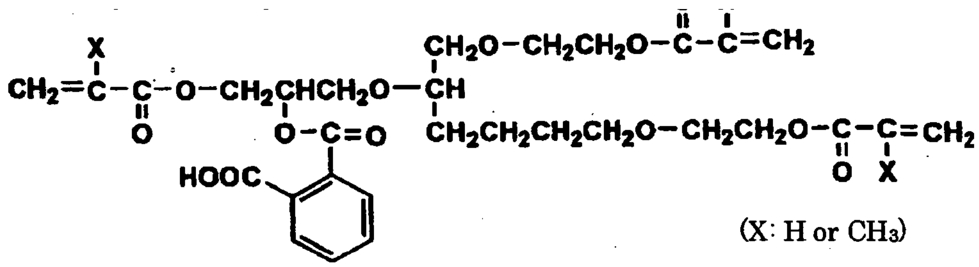

(X: H or $CH_3$)

The polymerizable compounds such as A10-1 and A10-2 as has been illustrated above can be prepared by the addition of an amine having a carboxyl group or an amino acid, in a broad sense, to the vinyl group of acrylic acid. More specifically, this reaction can generally be represented by the following reaction scheme:

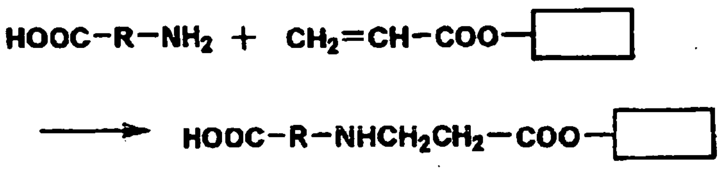

In this reaction scheme, R represents a methylene group in case of the polymerizable compound A10-1, or a phenylene group in case of the polymerizable compound A10-2. Examples of such amines each having a carboxyl group, usable in this method, include p-amino-benzoic acid, glycine, valine, leucine, isoleucine, serine, threonine, methionine and phenylalanine. In addition to these examples, substances having almost the same quality can be derived from, for instance, glutamic acid, and aspartic acid, each of which has two carboxyl groups in the molecule.

On the other hand, the polymerizable compounds belonging to those represented by the general formulas of Group B include, for instance, polymerizable compounds of Group B1 to Group B4 represented by the following formulas. In this regard, the symbols A and Rp appearing in the general formulas

**A:**

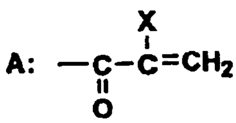

(X represents H or $CH_3$)

**$R_p$:** (COO- or salt thereof)

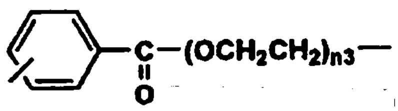

(n3 = an integer of 0 to 5)
or
($COO^-$ or salt thereof)

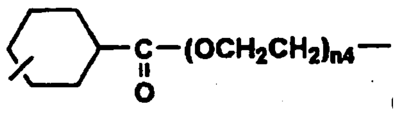

(n4 = an integer of 0 to 5)

representing the polymerizable compounds of Group B1 to Group B4 represent the following atomic groups, respectively:

Polymerizable Compound Group B1

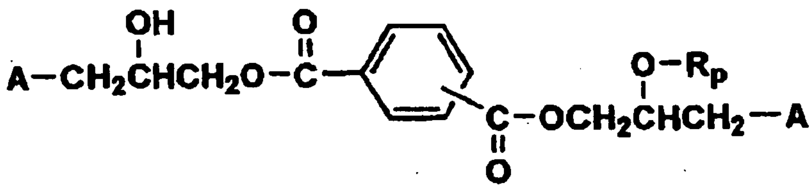

Polymerizable Compound Group B2

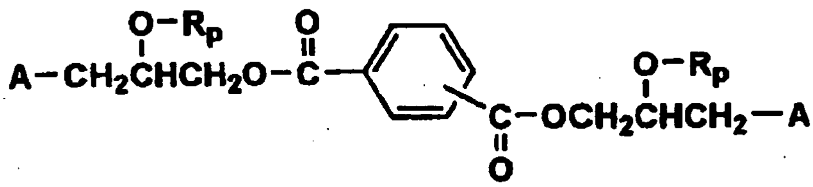

Polymerizable Compound Group B3

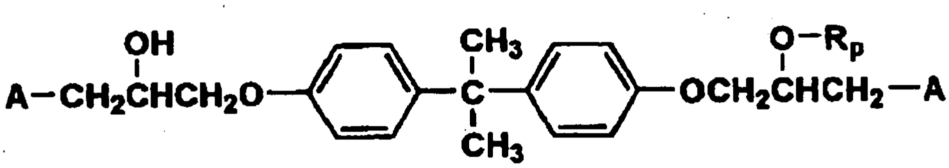

Polymerizable Compound Group B4

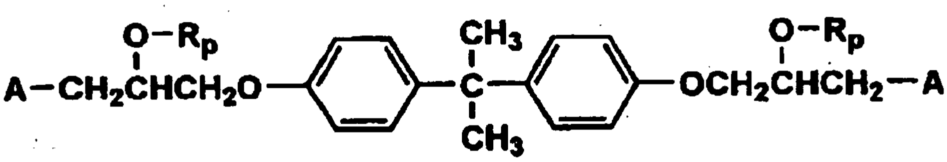

Polymerizable Compound Group B1-1

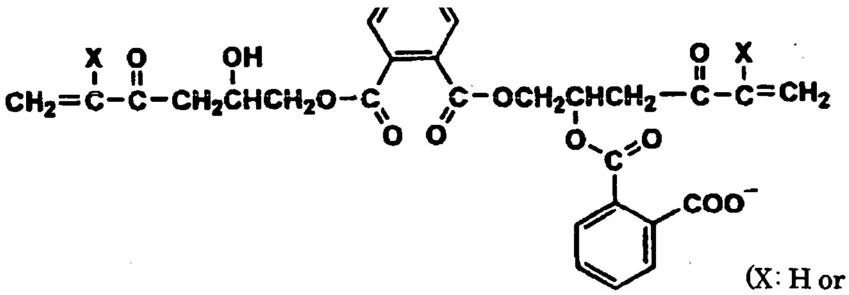

(X: H or CH3)

Polymerizable Compound Group B2-1

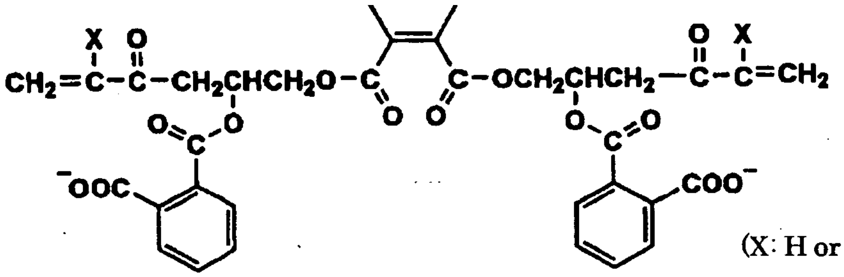

(X: H or CH3)

Polymerizable Compound Group B3-1

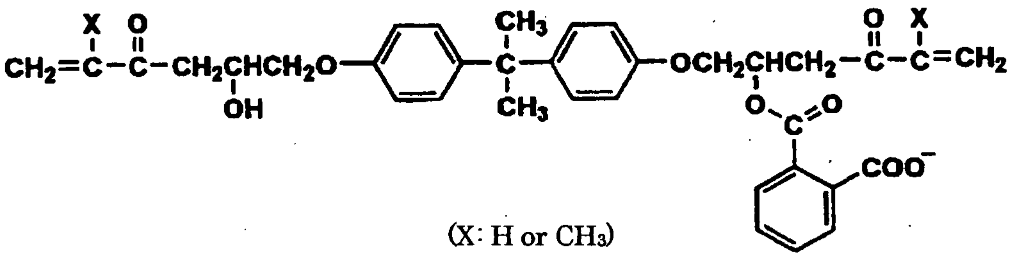

(X: H or CH3)

Polymerizable Compound Group B4-1

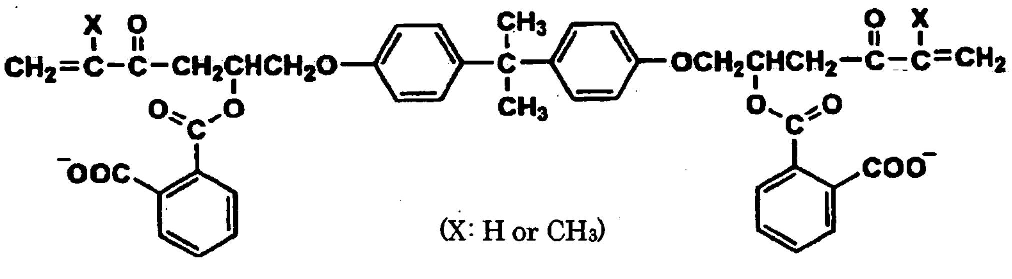

(X: H or CH3)

Among the foregoing compounds of a variety of groups, those each having three polymerizable functional groups in the molecule are particularly excellent in the polymerization rate, the hardness of the cured products, and the frictional resistance with respect to water. The reason of this tendency would be such that when polymerizing a compound having at least three reactive groups, the resulting product or polymer has a high density of crosslinking and a substantially reduced hydrophilicity.

The content of the photopolymerizable compound used in the present invention preferably ranges from 10 to 70% by mass and more preferably 20 to 55% by mass on the basis of the total mass of the photopolymerizable composition.

(1-3) Photopolymerization Initiator:

The photopolymerization initiator included in the composition of the present invention is a compound capable of initiating the polymerization of the foregoing photopolymerizable composition when it is irradiated with light rays. When the photopolymerizable composition is soluble in water, the composition and the initiator are preferably present in the same phase and therefore, the photopolymerization initiator is preferably soluble in water as well.

The following are detailed description of the photopolymerization initiators constituting the photopolymerizable composition of the present invention. Examples thereof include catalysts showing their functions upon the irradiation with light rays having a wavelength around 400 nm or less. Examples of such catalysts are photopolymerization initiators (hereunder referred to as "TX type initiator(s)" for simplicity) having a sensitivity that it can generate radicals upon the irradiation with ultraviolet light rays and/or visible radiation and represented by the following general formulas, and it is particularly preferred in the present invention to use the initiator appropriately selected from these examples:

**TX-1**

TX−1

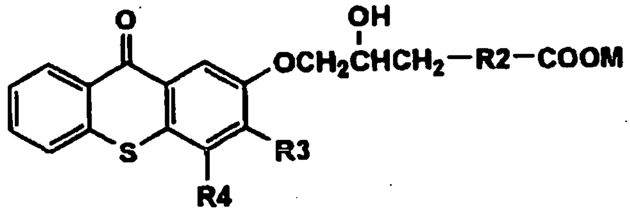

**TX-2**

TX−2

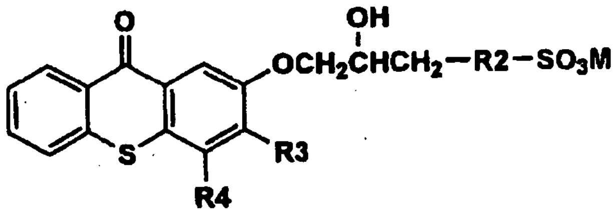

**TX-3**

TX−3

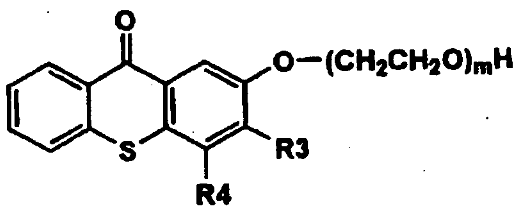

In the foregoing general formulas TX-1 to TX-3, R2 represents $-(CH_2)_x-$ (x = 0 or 1), $-O-(CH_2)_y-$ (y = 1 or 2), or a substituted or unsubstituted phenylene group. Moreover, when R2 represents a phenylene group, at least one of hydrogen atoms present on the benzene ring may be replaced with one or more than 2 groups or atoms selected from the groups consisting of, for instance, carboxyl group or salts thereof, sulfonate group or salts thereof, linear or branched alkyl groups each having 1 to 4 carbon atoms, halogen atoms (such as fluorine, chlorine and bromine atoms), alkoxy groups each having 1 to 4 carbon atoms, and aryloxy groups such as phenoxy group. In the foregoing general formulas, M represents a hydrogen atom or an alkali metal (such as Li, Na or K). Moreover, R3 and R4 each independently represent a hydrogen atom or a linear or branched alkyl group. In this respect, examples of such alkyl groups are linear or branched alkyl groups having 1 to 10 carbon atoms, in particular, those having about 1 to 3 carbon atoms. In addition, examples of substituents for these alkyl groups are halogen atoms (such as fluorine, chlorine and bromine atoms), hydroxyl group, and alkoxy groups (having 1 to about 3 carbon atoms). Moreover, m is an integer ranging from 1 to 10.

Thioxanthone substituted with these hydrophilic atomic groups is soluble in water and has a good compatibility with an anionic aqueous pigment dispersion. Further, it can serve as a catalyst having a high sensitivity in the pigment composition since the organic pigment per se shows only a low absorptivity.

Moreover, a water-soluble photopolymerization initiator used as a component of the photopolymerizable composition of the present invention may be a water-soluble derivative of the photopolymerization initiator: Irgacure 2959 (trade name of the product available from Ciba Specialty Chemicals Co., Ltd.) (hereunder referred to as "IC type photopolymerization initiator"). More specifically, usable herein include, for instance, IC-1 to IC-3 represented by the following formulas:

General Formula

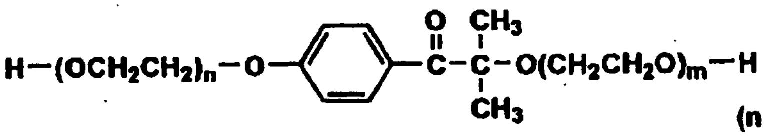

(n=2~5, m=0~5)

IC-1

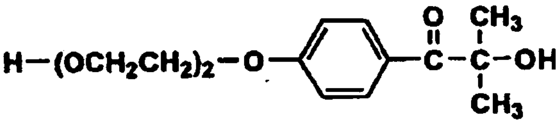

IC-2

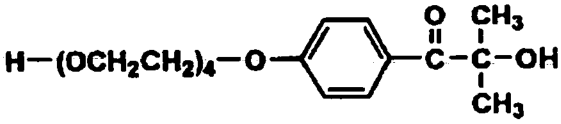

IC-3

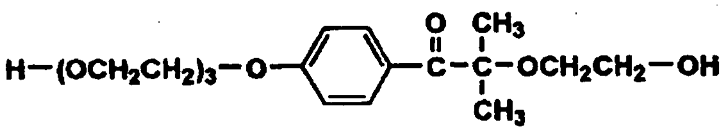

The foregoing substances IC-1 to IC-3 are nonionic compounds, but are sensitive to ultraviolet light rays whose wavelengths are shorter than those of the ultraviolet light rays to which the photopolymerization initiators TX-1 to TX-3 listed above are sensitive. In addition, the photopolymerization initiators IC-1 to IC-3 are soluble in water like the above mentioned photopolymerization initiators TX-1 to TX-3 and accordingly, they are useful as a component of the photopolymerizable composition of the present invention. Furthermore, it may likewise be possible to prepare a water-soluble derivative starting from the existing catalyst material (photopolymerization initiator) for the ultraviolet-polymerizable system and to use the resulting derivative as a photopolymerization initiator which constitutes the photopolymerizable composition of the present invention.

The content of the photopolymerization initiator used in the present invention preferably ranges from 0.1 to 20% by mass and more preferably 1 to 10% by mass on the basis of the total mass of the photopolymerizable composition. Alternatively, the amount thereof ranges from 2.5 to 30 parts by mass per 100 parts by mass of the photopolymerizable compound.

(2) Ink Jet Recording Method and Device Therefor

The photopolymerizable composition of the present invention can suitably be used as an actinic light ray-curable ink composition for use in the ink jet recording. The following are the description of the ink jet recording method and the ink jet recording device suitably used in the present invention.

(2-1) Actinic Light Ray-Curable Ink Composition for Ink Jet Recording

The ink jet recording ink composition preferably has a viscosity value, as determined at the injection temperature (for instance, 40 to 80°C, preferably 25 to 30°C), ranging from, for instance, 7 to 30 mPa · s and preferably 7 to 20 mPa

· s, while taking into consideration the injectability thereof. For instance, the viscosity value at room temperature (25 to 30°C) of the ink composition of the present invention ranges from 35 to 500 mPa · s and preferably 35 to 200 mPa · s. The mixing ratio of the ingredients contained in the ink composition of the present invention is preferably adjusted appropriately in such a manner that the viscosity thereof falls within the range specified above. The use of an ink composition, whose viscosity at room temperature is set at a high level, would permit the prevention of any penetration of the ink composition into a recording medium, the reduction of the amount of un-cured monomer and the reduction of the quantity of bad smells given out therefrom even when using a porous recording medium. Moreover, the control of the viscosity of the ink composition likewise prevents the occurrence of any bleeding on the impact of the ink droplets on the medium and as a result, the resulting images are improved in the quality.

The surface tension of the ink jet recording ink composition according to the present invention ranges, for instance, from 20 to 30 mN/m and preferably 23 to 28 mN/m. When images are formed on a variety of recording mediums such as polyolefin, PET, coated paper and uncoated paper, the surface tension of the ink composition is preferably not less than 20 mN/m, while taking into consideration the problems concerning the bleeding and penetration and not more than 30 mN/m, while taking into consideration the problem of wettability.

(2-2) Ink Jet Recording Method

The present invention likewise provides a method for forming images which comprises the steps of injecting the foregoing ink jet recording ink composition onto the surface of a recording medium or a substrate, and then irradiating the ink composition impacted on and adhered to the substrate with radiant rays to thus make the ink composition cure and to form intended images. More specifically, the present invention relates to a method comprising the following steps:

(a) A step for applying the foregoing ink composition onto the surface of a medium to be recorded (recording medium or substrate); and

(b) A step for curing the ink composition applied onto the recording medium by the irradiation thereof with radiant rays having a peak wavelength ranging from 200 to 600 nm, preferably 300 to 450 nm and more preferably 350 to 420 nm, at an output of not more than 2000 mJ/cm$^2$, preferably 10 to 2000 mJ/cm$^2$, more preferably 20 to 1000 mJ/cm$^2$, further preferably 50 to 800 mJ/cm$^2$, to thus form desired images on the recording medium.

The recording medium usable herein is not restricted to any specific one and it may, for instance, be the usual paper materials such as uncoated paper and coated paper; various kinds of non-absorptive resin materials used as so-called soft packaging materials; or resin films obtained by forming such soft packaging materials into film-like materials. Examples of various kinds of plastic films are PET films, OPS films, OPP films, ONy films, PVC films, PE films and TAC films. In addition to the foregoing, other plastic materials usable herein as recording mediums include polycarbonate, acrylic resins, ABS resins, polyacetal, PVA, and rubber materials. Moreover, also usable herein as recording mediums include metal and glass materials.

When selecting materials which show only a small degree of thermal shrinkage during a curing step and used in the ink composition of the present invention, the resulting ink composition is excellent in the adhesion to the recording medium after its curing. Therefore, such an ink composition shows such an advantage that it can form highly fine and precise images even on a film, which easily undergoes curling and deformation due to the shrinkage of the ink upon curing and the heat generated through the curing reaction of the ink composition, for instance, heat-shrinkable films such as PET films, OPS films, OPP films, ONy films, PVC films.

[Examples of Methods for Injecting and Impacting Ink Composition]

As an example of the method for injecting an ink composition onto the surface of a recording medium to thus impact the ink onto the medium, preferably used herein is the ink jet recording technique wherein a specially designed ink composition is injected through a nozzle in the form of fine droplets to thus adhere the droplets onto recording paper. The ink jet head may be divided into the Bubble Jet (registered trade mark) system in which air bubbles are generated by the application of a voltage to a heater to thus force out the ink, and piezoelectric element-system in which the ink is forced out by the vibrational action of the piezoelectric element. The ink composition of the present invention can be used in the ink jet recording device provided with either of these systems.

**[Examples]**

<u>(Preparation Example 1)</u>

There was dissolved 0.5 g of 2,9-dimethyl-quinacridone (HOSTAPERM PINKE available from Clariant Company), in 0.5 mL of dimethylsulfoxide, 0.85 mL of a 28% solution of sodium methoxide in methanol (available from WAKO Pure Chemical Co., Ltd.), and 2.0 mL of a DMSO solution containing 0.5 g of AQUALON KH-10 (available from Dai-Ichi Kogyo Seiyaku Co., Ltd.) and 0.10 g of methyl acrylate at room temperature (Liquid IA). The pH value of Liquid IA exceeded the detection limit (pH 14) and thus could not be determined. In this respect, distilled water was used as Liquid IIA. These liquids were passed through a microfilter having a pore size of 0.45 μ m (available from Sartorius Company), to thus remove any contaminant such as dust. Then the foregoing components were reacted according to the following procedures while using a simplified reaction device equipped with a flow path structure similar to that used in the device as shown in Fig. 1A. More specifically, both of the two inlets of a Y-shaped connector (available from Tokyo Rika Kikai K.K.) made of Teflon (registered trade mark) having an equivalent diameter of 500 μ m were connected to two separate Teflon tubes each having an equivalent diameter of 1 mm and a length of 50 cm, through respective connectors and the tips of these tubes were communicated with a syringe containing Liquid IA and a syringe containing Liquid IIA respectively and they were then connected to pumps. A Teflon tube having a length of 1.5 m and an equivalent diameter of 500 μ m was connected to the outlet opening of the Y-shaped connector. The liquids were fed to the tubes at liquid-supply speeds of 96 mL/h for Liquid IA and 600 mL/h for Liquid IIA (Reynolds number: about 500). A dispersion of 2,9-dimethyl- quinacridone could be recovered at the tip of the outlet opening of the tube and the dispersion thus collected was used as Sample 1 for comparison. The pH value of the sample 1 was found to be 13.0. Moreover, the volume average particle size Mv of Sample 1 was found to be 23.0 nm and the ratio: volume average particle size (Mv)/number average particle size (Mn), serving as the indication of monodispersibility, observed for Sample 1 was found to be 1.49.

Then this pigment dispersion was purified using an ultrafiltration device (UHP-25K available from Advantech Toyo Company; fractional molecular weight: 200,000), while supplementing distilled water so that the amount of liquid could be maintained at a predetermined level.

Furthermore, potassium persulfate ($K_2S_2O_8$) was added to the pigment dispersion in an amount of 5% of the AQUALON KH-10 included in the dispersion and the resulting mixture was heated at 70°C for 5 hours to thus give Sample 1a. Sample 1a was found to have a volume average particle size Mv of 21.5 nm and a ratio: volume average particle size (Mv)/number average particle size (Mn), serving as the indication of monodispersibility, of 1.45.

Sample 1 and Sample 1a were stored with heating at 70°C for 100 hours, respectively. The rate of variation in the volume average particle size (Mv) of Sample 1 was found to be 5.2% (the rate of variation in the volume average particle size: the value determined by dividing the volume average particle size (Mv) observed after the storage with heating by the volume average particle size (Mv) observed before the heat-storage treatment and then subtracting 1 from the resulting quotient), while the rate of variation in the volume average particle size of Sample 1a was found to be 2.3%. These results clearly indicate that the polymerization treatment would permit the improvement of the stability of the resulting dispersion. In addition, the foregoing difference in the rate of variation in the volume average particle size due to the heat-storage treatment likewise indicates that the long term storage stability of the dispersion would be ensured when it is used as an ink jet recording ink composition and such a small rate of variation clearly indicates that the dispersion is more suitably used as an ink composition.

(Preparation Example 2)

A dispersion was prepared by repeating the same procedures used in Preparation Example 1 except for using the same mass of SE-10N (available from Asahi Denka Kogyo K.K.) instead of AQUALON KH-10 used in Preparation Example 1 and this was defined to be Sample 2 for comparison. Further, Sample 2 was subjected to the same polymerization treatment used in Preparation Example 1 to thus form Sample 2a according to the present invention. The volume average particle size Mv of Sample 2 was found to be 25.6 nm and the ratio: volume average particle size (Mv) /number average particle size (Mn), serving as the indication of monodispersibility, of Sample 2 was found to be 1.46. The volume average particle size Mv of Sample 2a was found to be 22.6 nm and the ratio: volume average particle size (Mv)/number average particle size (Mn) observed for Sample 2a was found to be 1.44. Moreover, these samples were subjected to a heat-storage treatment according to the same method used in Preparation Example 1 and the samples after such a treatment were inspected for the rate of variation in the volume average particle size (Mv). As a result, the rates were found to be 5.6% for Sample 2 and 2.2% for Sample 2a. These results clearly indicate that the polymerization treatment would permit the improvement of the stability of the resulting dispersion.

(Preparation Example 3)

A dispersion was prepared by repeating the same procedures used in Preparation Example 1 except for using Pigment Yellow 128 (available from Ciba Specialty Chemicals Co., Ltd.) in place of the 2,9-dimethyl-quinacridine used in Preparation Example 1 and this was defined to be Sample 3 for comparison. Further, Sample 3 was subjected to the same polymerization treatment used in Preparation Example 1 to thus form Sample 3a according to the present invention. The volume average particle size Mv of Sample 3 was found to be 33.3 nm and the ratio: volume average particle size

(Mv)/number average particle size (Mn), serving as the indication of monodispersibility, of Sample 3 was found to be 1.44. The volume average particle size Mv of Sample 3a was found to be 29.9 nm and the ratio: volume average particle size (Mv)/number average particle size (Mn) observed for Sample 3a was found to be 1.40.

Sample 3 and Sample 3a were stored with heating at 70°C for 100 hours, respectively and the samples after such a treatment were inspected for the rate of variation in the volume average particle size (Mv). As a result, the rates of variation in the volume average particle size (Mv) were found to be 5.6% for Sample 3 and 3.2% for Sample 3a. These results clearly indicate that the polymerization treatment would permit the improvement of the stability of the resulting dispersion.

(Preparation Example 4)

A dispersion was prepared by repeating the same procedures used in Preparation Example 1 except for using Pigment Blue 16 (Phthalocyanine Di-sodium available from Tokyo Kasei Kogyo Co., Ltd.) in place of the 2,9-dimethylquinacridine used in Preparation Example 1 and for using N-methyl-pyrrolidone instead of the dimethylsulfoxide used in Preparation Example 1, and this was defined to be Sample 4 for comparison. Further, Sample 4 was subjected to the same polymerization treatment used in Preparation Example 1 to thus form Sample 4a according to the present invention. The volume average particle size Mv of Sample 4 was found to be 42.7 nm and the ratio: volume average particle size (Mv)/number average particle size (Mn), serving as the indication of monodispersibility, of Sample 4 was found to be 1.49. The volume average particle size Mv of Sample 4a was found to be 39.6 nm and the ratio: volume average particle size (Mv)/number average particle size (Mn), serving as the indication of monodispersibility, observed for Sample 4a was found to be 1.43.

Sample 4 and Sample 4a were stored with heating at 70°C for 100 hours, respectively and the samples after such a treatment were inspected for the rate of variation in the volume average particle size (Mv). As a result, the rates of variation in the volume average particle size (Mv) were found to be 4.6% for Sample 4 and 3.0% for Sample 4a. These results clearly indicate that the polymerization treatment would permit the improvement of the stability of the resulting dispersion.

(Comparative Preparation Example 1)

A dispersion was prepared by repeating the same procedures used in Preparation Example 1 except that in the solution of the polymerizable compound in DMSO, the amount of the AQUALON KH-10 used in Preparation Example 1 was changed from 0.5 g to 0.25 g and that of the methyl acrylate used in Preparation Example 1 was changed from 0.10 g to 0.05 g and this was defined to be Sample 5. The volume average particle size Mv of Sample 5 was found to be 58.0 nm and the ratio: volume average particle size (Mv)/number average particle size (Mn), serving as the indication of monodispersibility, of Sample 5 was found to be 1.80.

Then AQUALON KH-10 was added to this pigment dispersion in an amount corresponding to 30% by mass of the amount of AQUALON KH-10 present in the dispersion, the resulting mixture was stirred at room temperature for one hour, $K_2S_2O_8$ was further added in an amount of 5% by mass of that of the AQUALON KH-10 present in the dispersion and the mixture was further heated at 70°C for 5 hours to thus give Sample 5a. The volume average particle size Mv of Sample 5a was found to be 52.8 nm and the ratio: volume average particle size (Mv)/number average particle size (Mn), serving as the indication of monodispersibility, of Sample 5a was found to be 1.66.

Sample 5 and Sample 5a were stored with heating at 70°C for 100 hours, respectively and the samples after such a treatment were inspected for the rate of variation in the volume average particle size (Mv). As a result, the rates of variation in the volume average particle size (Mv) (the rate of variation in the volume average particle size: the value determined by dividing the volume average particle size (Mv) observed after the storage with heating by the volume average particle size (Mv) observed before the heat-storage treatment and then subtracting 1 from the resulting quotient) were found to be 15.1% for Sample 5 and 14.9% for Sample 5a.

With respect to the pigment dispersions thus prepared, the pigment dispersion 1a prepared in Preparation Example 1 was hereunder referred to as Magenta Pigment Dispersion 1; the pigment dispersion 2a prepared in Preparation Example 2 as Magenta Pigment Dispersion 2; the pigment dispersion 3a prepared in Preparation Example 3 as Yellow Pigment Dispersion 1; the pigment dispersion 4a prepared in Preparation Example 4 as Blue Pigment Dispersion 1; and the pigment dispersion 5a prepared in Comparative Preparation Example 1 as Magenta Pigment Dispersion 3.

**Example 1**

<<Preparation of Ink>>

Each color ink was prepared using the respective dispersion prepared above according to the following method:

| (Magenta Ink 1) | |
|---|---|
| Component | Amt. (part by mass) |
| Magenta Pigment Dispersion 1 | 20 |
| Photopolymerizable compoundA3-1 | 35 |
| Photopolymerization initiator 1 (specified below) | 3 |
| Water | 42 |
| *: Photopolymerization initiator 1: | |

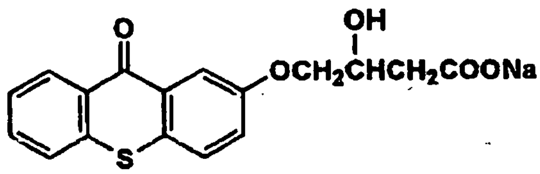

| (Magenta Ink 2) | |
|---|---|
| Component | Amt. (part by mass) |
| Magenta Pigment Dispersion 2 | 20 |
| Photopolymerizable compound A3-1 | 35 |
| Photopolymerization initiator 1 (specified above) | 3 |
| Water | 42 |

| (Yellow Ink 1) | |
|---|---|
| Component | Amt. (part by mass) |
| Yellow Pigment Dispersion 1 | 20 |
| Photopolymerizable compound A3-1 | 35 |
| Photopolymerization initiator 1 (specified above) | 3 |
| Water | 42 |

| (Blue Ink 1) | |
|---|---|
| Component | Amt. (part by mass) |
| Blue Pigment Dispersion 1 | 20 |
| Photopolymerizable compound A3-1 | 35 |
| Photopolymerization initiator 1 (specified above) | 3 |
| Water | 42 |

| (Comparative Example: Magenta Ink 3) | |
|---|---|
| Component | Amt. (part by mass) |
| Magenta Pigment Dispersion 3 | 20 |
| Photopolymerizable compound A3-1 | 35 |
| Photopolymerization initiator 1 (specified above) | 3 |
| Water | 42 |

<<Evaluation of Dispersion Stability>>

First of all, each of the resulting ink was inspected for the appearance and as a result, Magenta Inks 1 to 2, Yellow Ink 1 and Blue Ink 1 were found to be transparent, but Magenta Ink 3 was found to be relatively turbid and opaque.
Then each of these ink compositions was allowed to stand at 70°C for three months to thus inspect them for the agglomeration and the following results were thus obtained: There were not observed any agglomeration in Magenta Inks 1 to 2, Yellow Ink 1 and Blue Ink 1, but there was observed distinct agglomeration in Magenta Ink 3.
More specifically, the foregoing results clearly indicate that the use of the organic pigment dispersion according to the present invention makes it possible to distinctly improve the dispersion stability of the resulting ink composition.

<<Application of Ink to Aluminum Plate, Evaluation Thereof After Photo-setting>>

Each of the foregoing Magenta Ink Nos. 1 to 3 prepared according to the foregoing methods was applied onto the surface of an aluminum plate according to the bar-coating technique so that the thickness of the resulting film fell within the range of from 20 to 30 nm, and then the film was irradiated with UV light rays using Spot UV Exposure Machine to thus photo-set the film. At this stage, the light-exposure steps were all carried out at a predetermined exposure energy on the order of 300 $mJ/cm^2$.
At this stage, each ink film was inspected for the curability and the glossiness of the resulting cured product. As a result, there were observed uniform glossy feeling for Magenta Inks 1 to 2, Yellow Ink 1 and Blue Ink 1, but there was observed conspicuous rough feeling for Magenta Ink 3.

<<Evaluation upon Ink Jet Image-Recording Operation>>

Then, images were recorded on a recording medium using a commercially available ink jet recording device provided with a piezo-electrically operating ink jet nozzle. In this device, an ink supply system comprises a main tank, a supply-piping, an ink supply tank arranged immediately before the ink jet head, a filter, and a piezo-electrically operating ink jet head and the region of the device extending from the ink supply tank to the ink jet head was thermally isolated and warmed. Temperature sensors were arranged in the proximity to the ink supply tank and the nozzle of the ink jet head, respectively and the temperature of the nozzle was controlled in such a manner that it was always maintained at a level of 70°C$\pm$2°C. The piezo-electrically operating ink jet head was operated so as to be able to inject ink in the form of multi-sized dots of 8 to 30 pl at a resolution of 720$\times$720 dpi. After the completion of the impact, UV-A light rays were collected to a luminous intensity on the exposed surface of 100 $mW/cm^2$ and the light-exposure system, the main scanning speed and the frequency for injecting the ink were so controlled that the irradiation of the light rays could be initiated after 0.1 second from the impact of the ink on the surface of the recording medium. Moreover, the images were irradiated with the exposure energy for a variable exposure time. In this respect, the term "dpi" used herein represents the number of dots per unit length (2.54 cm).
Using the foregoing ink compositions having various colors and prepared above, the magenta ink was injected at an environmental temperature of 25°C and then the ink impacted on the recording medium was irradiated with ultraviolet rays. In this respect, the images were irradiated at a uniform exposure energy of 300 $mJ/cm^2$ corresponding to a level at which the ink completely lost its stickiness as determined by the examination by touch and it was completely cured. The recording mediums used herein were a surface-grained aluminum substrate, a transparent biaxially oriented polypropylene film having printability in advance through a surface-treatment, a soft vinyl chloride sheet, cast-coated paper, and commercially available regenerated paper and images were recorded on these mediums.
When using Magenta Inks 1 to 2, Yellow Ink 1 and Blue Ink 1, there were obtained images, at high resolution, which were free of any bleeding and excellent in the glossy feeling. On the other hand, the use of Magenta Ink 3 resulted in the formation of images which showed bleeding and rough feeling.

**Claims**

1. A photopolymerizable composition comprising the following components:

    a) a photopolymerizable compound;
    b) a photopolymerization initiator; and
    c) organic pigment fine particles on which a polymer formed from a polymerizable compound is immobilized,

    wherein the volume average particle size: Mv of the organic pigment fine particles is not more than 50 nm, and the ratio: Mv/Mn (wherein Mv represents the volume average particle size of the organic pigment fine particles and Mn represents the number average particle size of the same particles) ranges from 1 to 1.5, and
    wherein the organic pigment fine particles are prepared by a method comprising a step of incorporating the polymerizable compound into either or both of an alkaline or acidic solution containing an organic pigment and an aqueous medium, blending the alkaline or acidic solution and the medium together to thus separate out fine particles of the foregoing pigment, and then polymerizing the polymerizable compound to thus immobilize the polymer of the polymerizable compound onto the surface of the organic fine particles.

2. The photopolymerizable composition of claim 1, wherein the organic pigment fine particles are present in the form of a dispersion thereof in water.

3. The photopolymerizable composition of claim 1 or 2, which is an actinic light ray-curable ink composition for use in the ink jet recording method.

4. The photopolymerizable composition of any one of claims 1 to 3, wherein the volume average particle size: Mv of the organic pigment fine particles is from 3 to 40 nm.

5. The photopolymerizable composition of any one of claims 1 to 4, wherein Mv/Mn ranges from 1.3 to 1.5.

6. The photopolymerizable composition of any one of claims 1 to 5, wherein the organic pigment fine particles have a rate of variation of not more than 6.0%, wherein the rate of variation is determined after a heating/storing treatment.

7. The photopolymerizable composition of any one of claims 1 to 6, wherein the amount of polymer on the organic pigment fine particles ranges from 80 to 400 parts by mass, based on 100 parts by mass of the pigment.

8. The photopolymerizable composition of claim any one of claims 1 to 7, wherein the polymerizable compound is a polymerizable surfactant.

**Patentansprüche**

1. Fotopolymerisierbare Zusammensetzung, die die folgenden Komponenten umfasst:

    a) eine fotopolymerisierbare Verbindung;
    b) ein Fotopolymerisationsinitiator; und
    c) feine Partikel organischer Pigmente auf denen ein Polymer aus einer polymerisierbaren Verbindung immobilisiert ist;

    wobei die volumengemittelte Partikelgröße: Mv der feinen Partikel organischer Pigmente nicht mehr als 50 nm und das Verhältnis: Mv/Mn im Bereich von 1 bis 1,5 ist (wobei Mv die volumengemittelte Partikelgröße der feinen Partikel organischer Pigmente ist und Mn die zahlengemittelte Partikelgröße der gleichen Partikel ist) und
    worin die feinen Partikel organischer Pigmente durch ein Verfahren hergestellt werden, welches die folgenden Schritte umfasst: Aufnehmen der polymerisierbaren Verbindung in eine alkalische oder saure Lösung, die ein organisches Pigment enthält und/oder in ein wässriges Medium, Zusammenmischen der alkalischen oder sauren Lösung mit dem Medium zur Abtrennung von feinen Partikeln des obengenannten Pigments und anschließend Polymerisieren der polymerisierbaren Verbindung zur Immobilisierung des Polymers der polymerisierbaren Verbindung auf der Oberfläche der organischen feinen Partikel.

2. Fotopolymerisierbare Zusammensetzung gemäß Anspruch 1, worin die feinen Partikel organischer Pigmente in

Form einer Dispersion im Wasser vorliegen.

3. Fotopolymerisierbare Zusammensetzung gemäß Anspruch 1 oder 2, die eine durch aktinisches Lichtstrahl-härtbare Tintenzusammensetzung zur Verwendung in einem Tintenstrahlaufzeichnungsverfahren ist.

4. Fotopolymerisierbare Zusammensetzung gemäß irgendeinem der Ansprüche 1 bis 3, worin die volumengemittelte Partikelgröße: Mv der feinen Partikel organischer Pigmente von 3 bis 40 nm ist.

5. Fotopolymerisierbare Zusammensetzung gemäß irgendeinem der Ansprüche 1 bis 4, worin Mv/Mn im Bereich von 1,3 bis 1,5 ist.

6. Fotopolymerisierbare Zusammensetzung gemäß irgendeinem der Ansprüche 1 bis 5, worin die feinen Partikel organischer Pigmente einen Veränderungsgrad von nicht mehr als 6,0 % aufweisen, wobei der Veränderungsgrad nach einer Wärme-/Lagerungsbehandlung bestimmt ist.

7. Fotopolymerisierbare Zusammensetzung gemäß irgendeinem der Ansprüche 1 bis 6, worin die Menge des Polymers auf den feinen Partikeln organischer Pigmente im Bereich von 80 bis 400 Masse-Teile bezogen auf 100 Masse-Teile des Pigments ist.

8. Fotopolymerisierbare Zusammensetzung gemäß irgendeinem der Ansprüche 1 bis 7, worin die polymerisierbare Verbindung ein polymerisierbares Tensid ist.

## Revendications

1. Composition photopolymérisable comprenant les composants suivantes :

   a) un composé photopolymérisable ;
   b) un initiateur de photopolymérisation ; et
   c) des fines particules de pigment organique sur lesquelles un polymère formé à partir d'un composé polymérisable est immobilisé,

   dans lequel la taille de particule moyenne en volume : Mv des fines particules de pigment organique n'est pas supérieure à 50 nm, et le rapport : Mv / Mn (dans lequel Mv représente la taille de particule moyenne en volume des fines particules de pigment organique et Mn représente la taille de particule moyenne en nombre des mêmes particules) est compris entre 1 et 1,5, et
   dans laquelle les fines particules de pigment organique sont préparées par un procédé comprenant une étape d'incorporation du composé polymérisable dans l'une ou l'autre ou les deux d'une solution alcaline ou acide contenant un pigment organique et d'un milieu aqueux, de mélange de la solution alcaline ou acide et du milieu ensemble pour séparer ainsi des fines particules du pigment précédent, et ensuite de polymérisation du composé polymérisable pour immobiliser ainsi le polymère du composé polymérisable sur la surface des fines particules organiques.

2. Composition photopolymérisable selon la revendication 1, dans laquelle les fines particules de pigment organique sont présentes sous la forme d'une dispersion de celles-ci dans de l'eau.

3. Composition photopolymérisable selon la revendication 1 ou 2, qui est une composition d'encre pouvant être durcie par un rayonnement de lumière actinique pour utilisation dans le procédé d'enregistrement à jet d'encre.

4. Composition photopolymérisable selon l'une quelconque des revendications 1 à 3, dans laquelle la taille de particule moyenne en volume : Mv des fines particules de pigment organique est de 3 à 40 nm.

5. Composition photopolymérisable selon l'une quelconque des revendications 1 à 4, dans laquelle Mv / Mn est compris entre 1,3 et 1,5.

6. Composition photopolymérisable selon l'une quelconque des revendications 1 à 5, dans laquelle les fines particules de pigment organique ont un taux de variation non supérieur à 6,0 %, dans lequel le taux de variation est déterminé après un traitement de chauffage / stockage.

**7.** Composition photopolymérisable selon l'une quelconque des revendications 1 à 6, dans laquelle la quantité de polymère sur les fines particules de pigment organique est comprise entre 80 et 400 parties en masse, sur base de 100 parties en masse du pigment.

**8.** Composition photopolymérisable selon l'une quelconque des revendications 1 à 7, dans laquelle le composé polymérisable est un agent de surface polymérisable.

FIG.1A

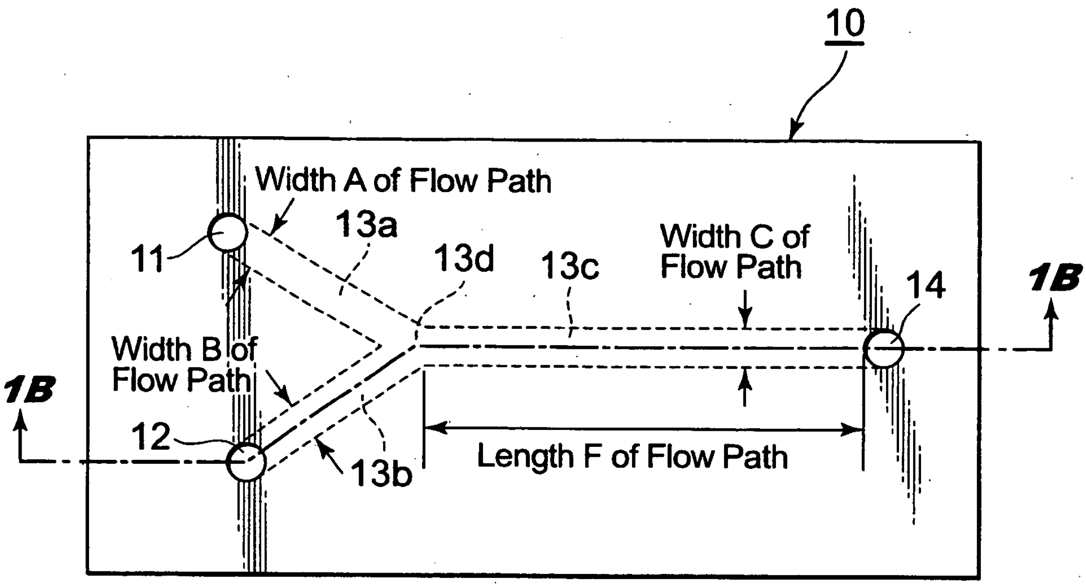
10
Width A of Flow Path
13a
11
13d
13c
Width C of Flow Path
14
1B
Width B of Flow Path
1B
12
13b
Length F of Flow Path

FIG.1B

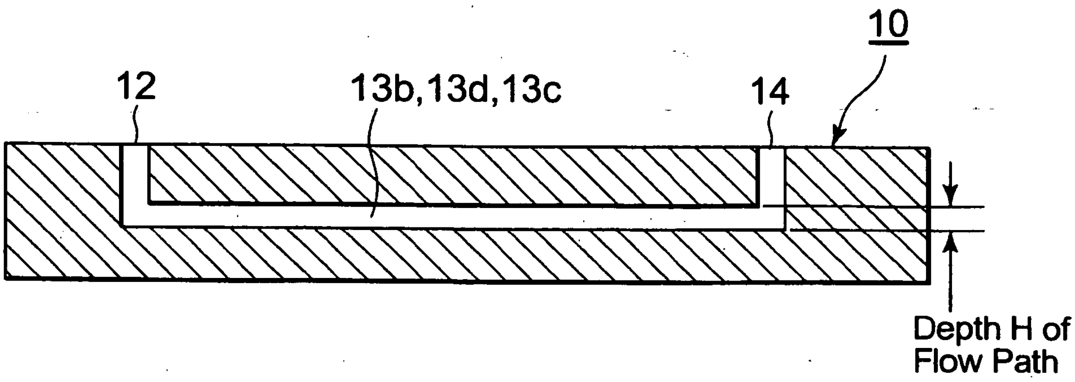
10
12
13b,13d,13c
14
Depth H of Flow Path

FIG.2A

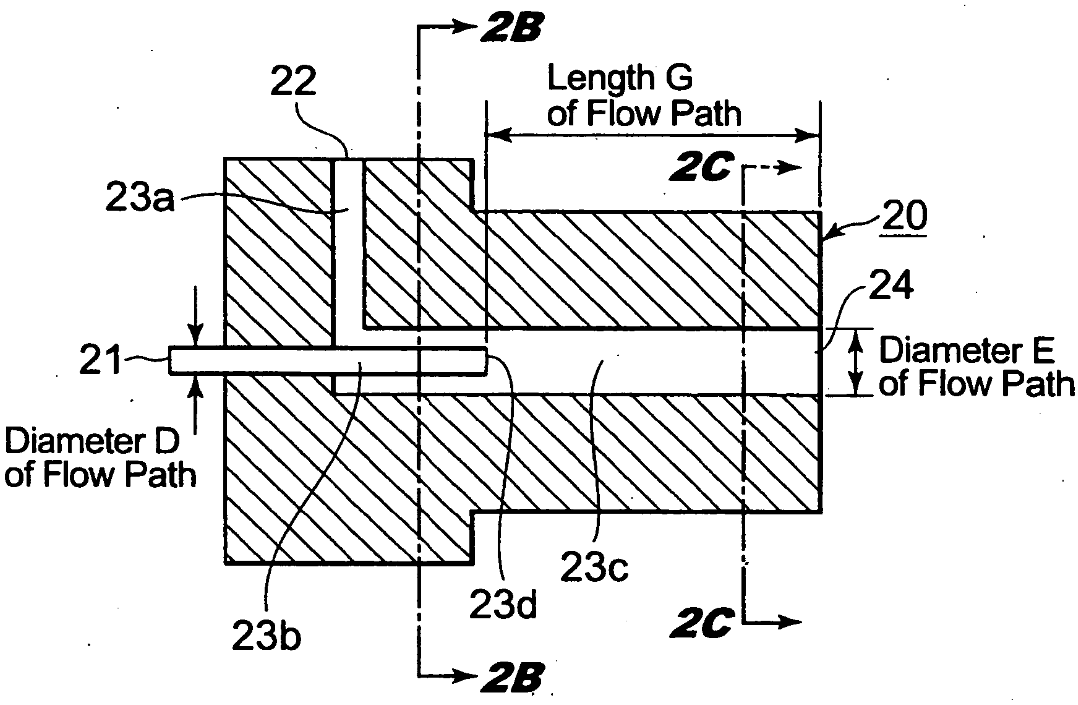
2B
22
Length G
of Flow Path
2C
23a
20
24
21
Diameter E
of Flow Path
Diameter D
of Flow Path
23c
23d
23b
2C
2B

FIG.2B

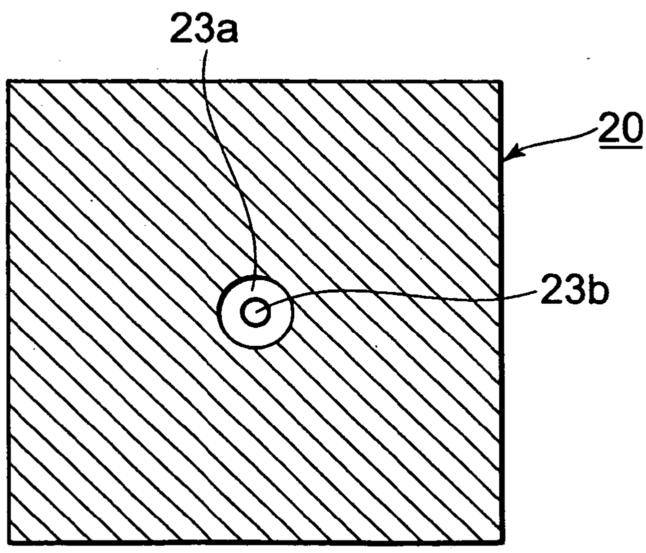
23a
20
23b

FIG.2C

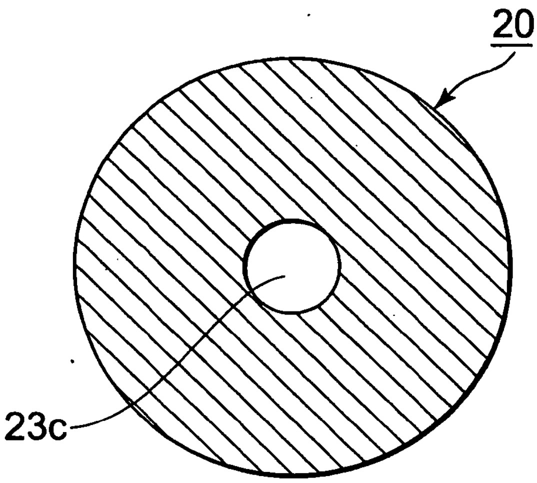
20
23c

FIG.3A

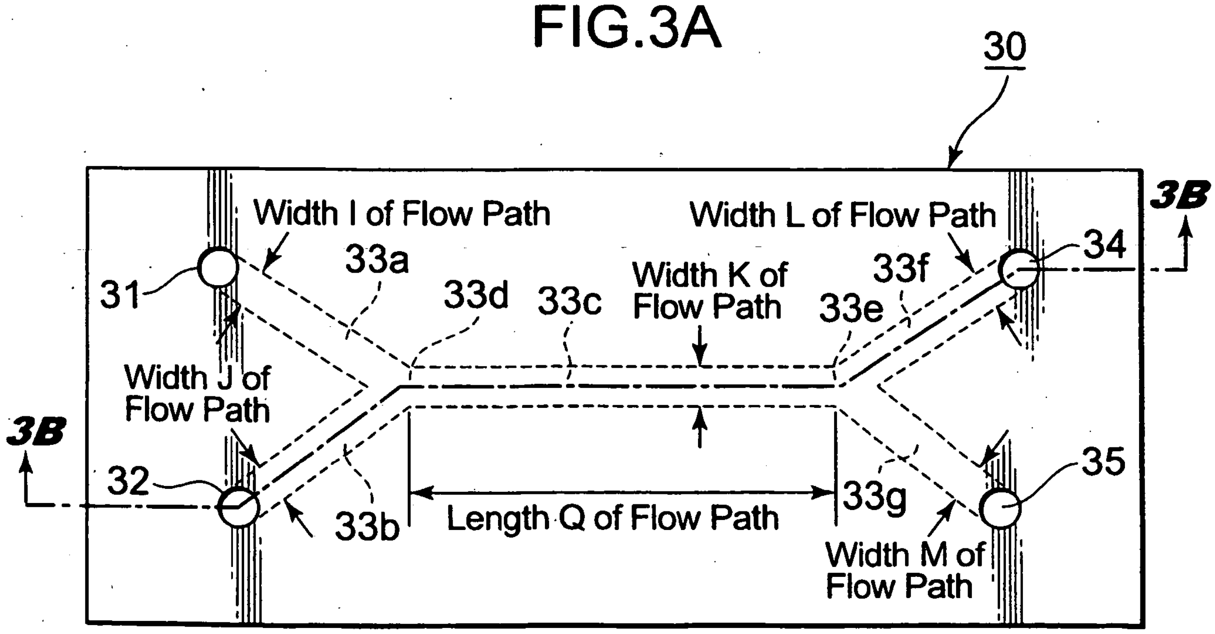
30
3B
Width I of Flow Path
Width L of Flow Path
34
31
33a
33d
33c
Width K of
Flow Path
33f
33e
Width J of
Flow Path
3B
32
33b
Length Q of Flow Path
33g
35
Width M of
Flow Path

FIG.3B

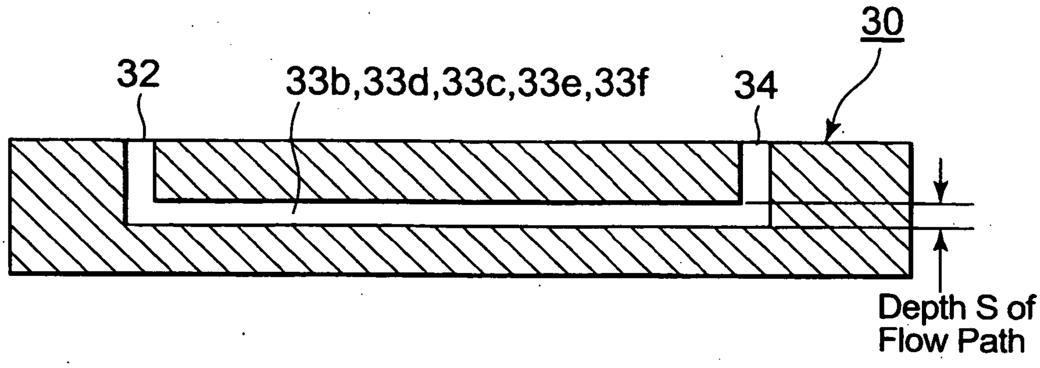
30
32
33b,33d,33c,33e,33f
34
Depth S of
Flow Path

FIG.4

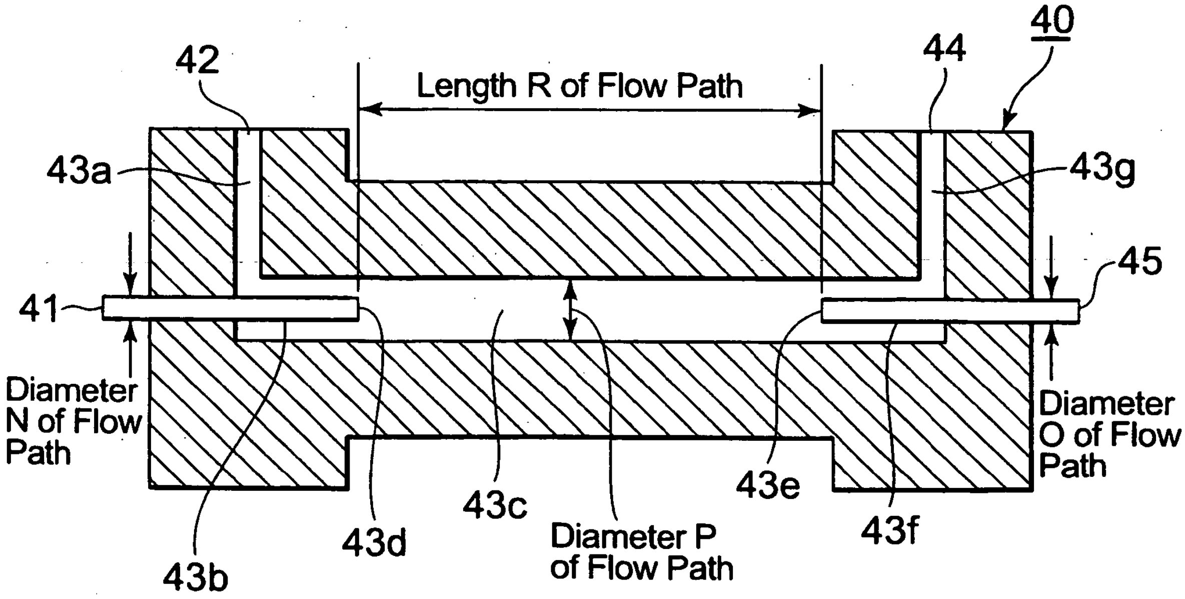
40
42
44
Length R of Flow Path
43a
43g
45
41
Diameter
N of Flow
Path
Diameter
O of Flow
Path
43e
43c
43f
43d
Diameter P
of Flow Path
43b

FIG.5

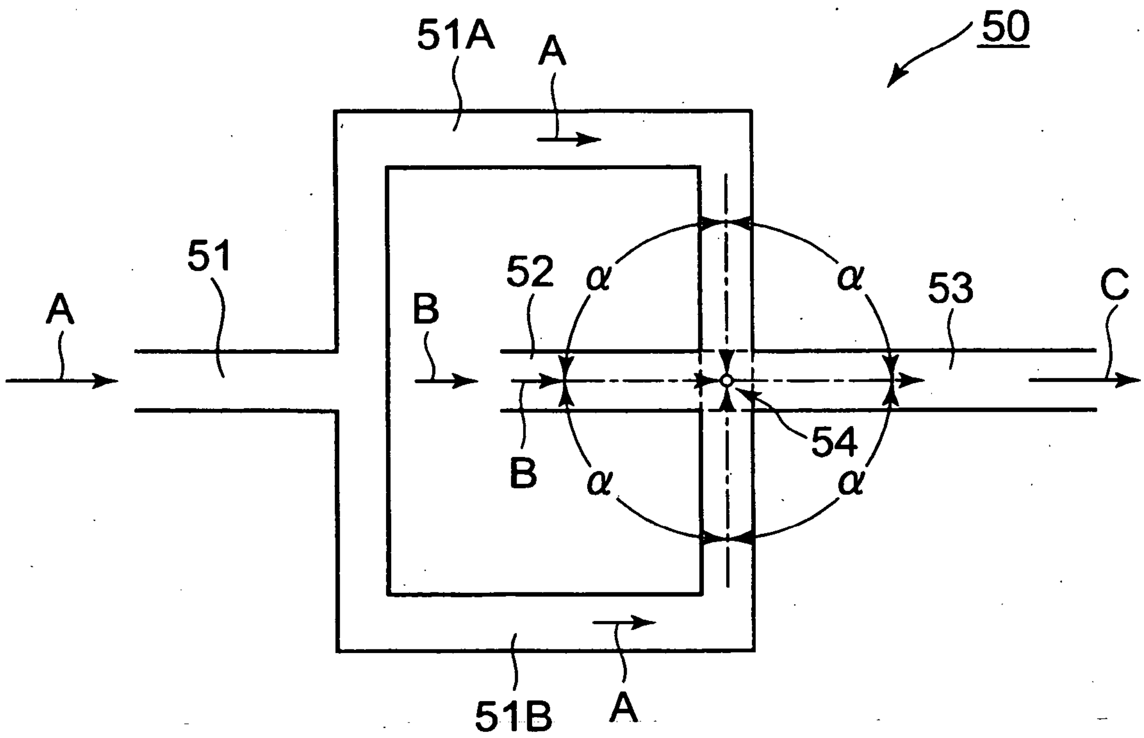

FIG.6

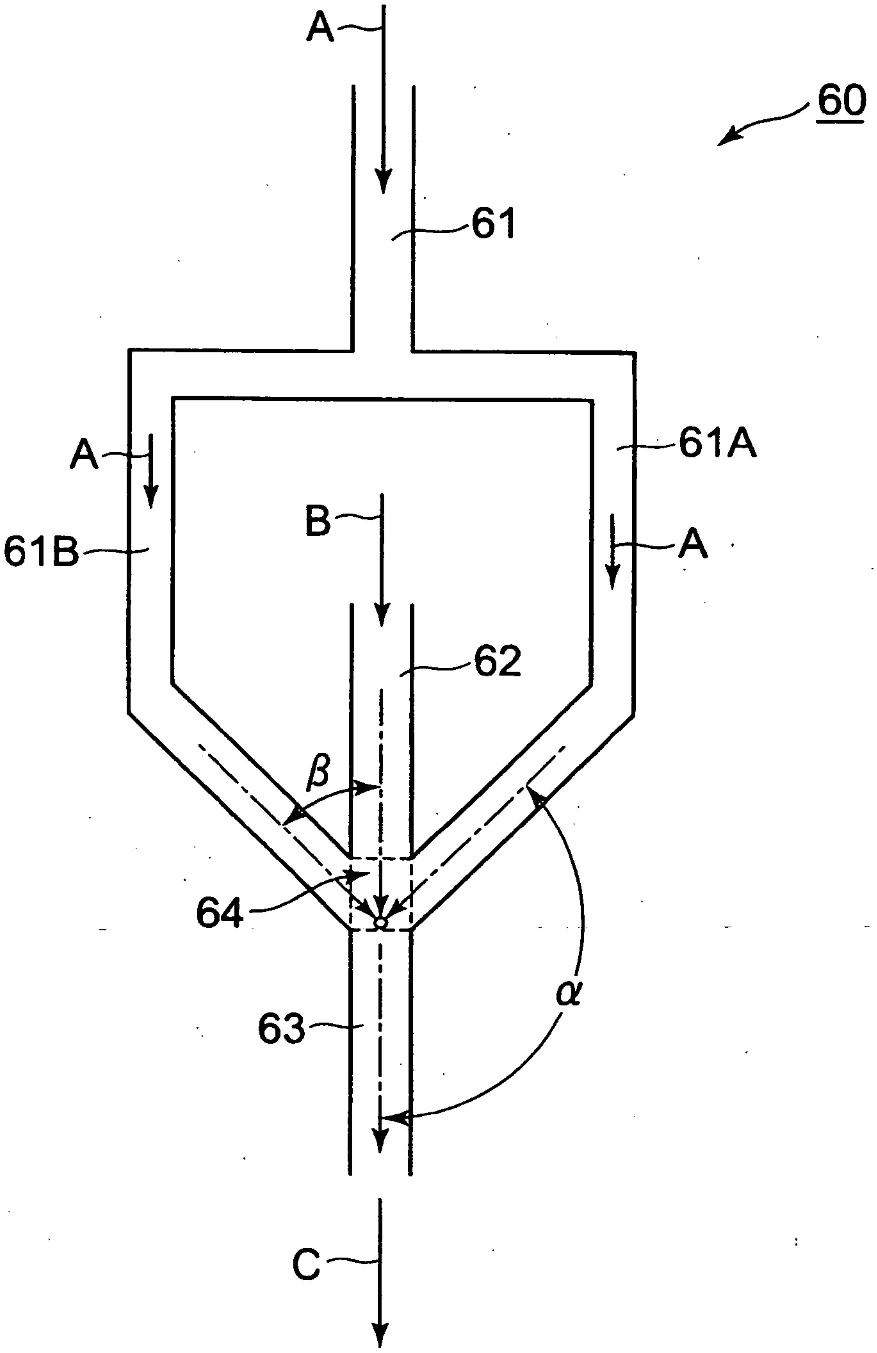

FIG.7

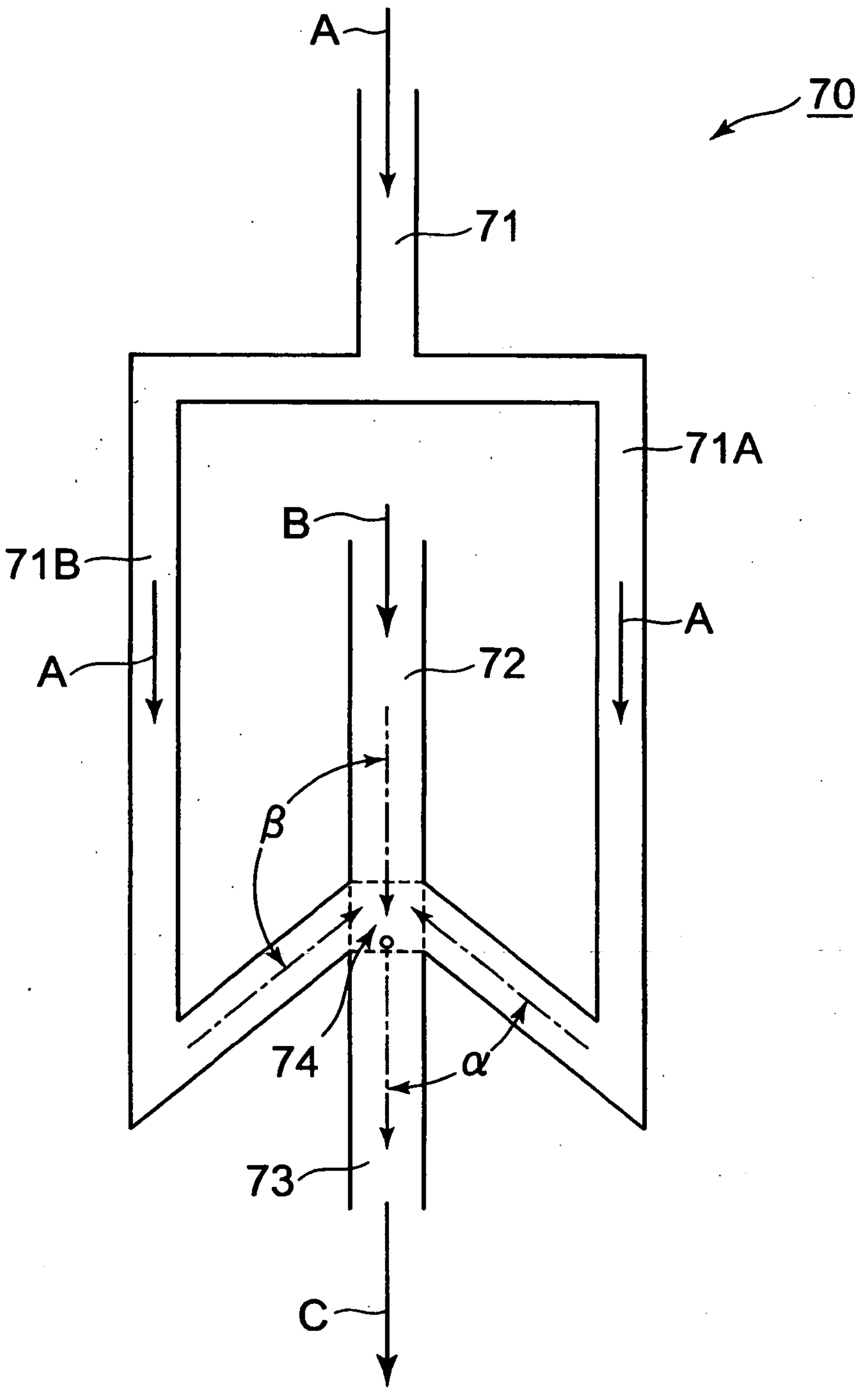

FIG.8

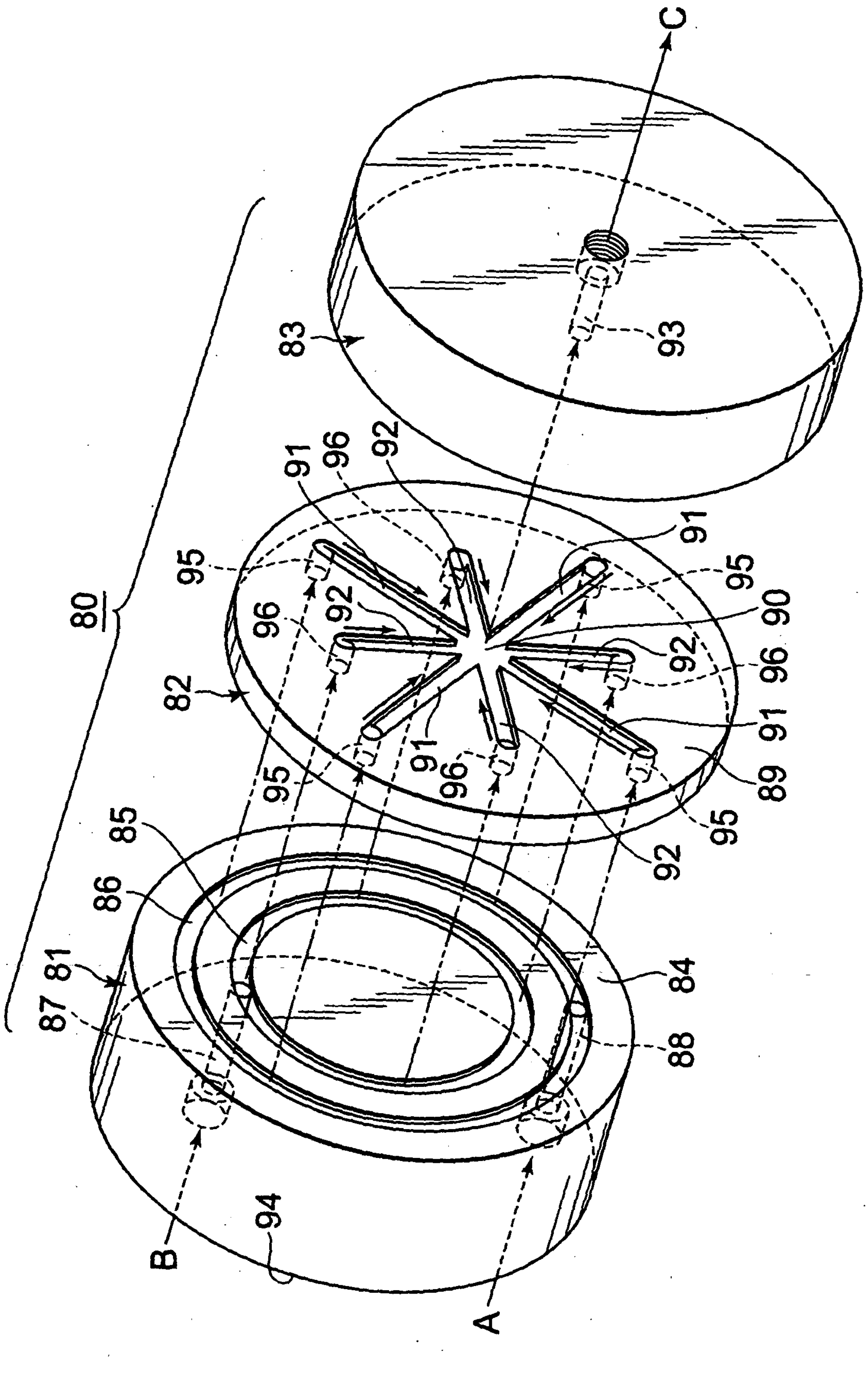

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005307154 A
- EP 0953613 A
- US 5679138 A
- JP 2002155221 A
- US 6537364 B
- JP 2003210960 A
- JP 2003210963 A
- JP 2003210959 A
- JP 2005046650 A
- JP 2005046651 A
- JP 2005046652 A
- JP 2005288254 A
- JP 3273067 A
- JP 2002194263 A
- JP 2003026972 A


### Non-patent literature cited in the description


- Jikken Kagaku Koza (Experimental Chemistry. MARUZEN Publishing Co., Ltd, vol. 12, 411-488
- Jikken Kagaku Koza (Experimental Chemistry. vol. 12, 411-488
- Kikai-Kougaku-Jiten'' (Mechanical Engineering Dictionary. MARUZEN Publishing Co., Ltd, 1997
- **W. EHRFELD ; V. HESSEL ; H. LOEWE.** Microreactor. WILEY-VCH, 2000
- Biryushi-Huntai-no-Saisentan-Gijutu'' (Most Advanced Fine Particles Powdered Bodies. CMC Publishing Company, 2000, 23-31
- Pigment Dispersion-Stabilization and Surface-Treating Technique · Evaluation. Society of Chemical Information, December 2001, 29-46